Europäisches Patentamt

European Patent Office

Office européen des brevets

(11) Publication number: **0 406 020 A2**

# EUROPEAN PATENT APPLICATION

(21) Application number: 90307183.5

(22) Date of filing: 29.06.90

(51) Int. Cl.⁵: **G06F 15/60**

A request for correction of description and claims has been filed pursuant to Rule 88 EPC. A decision on the request will be taken during the proceedings before the Examining Division (Guidelines for Examination in the EPO, A-V, 2.2).

(30) Priority: 30.06.89 JP 168351/89

(43) Date of publication of application:
**02.01.91 Bulletin 91/01**

(84) Designated Contracting States:
**DE FR GB**

(71) Applicant: **MITSUBISHI DENKI KABUSHIKI KAISHA**
**2-2-3, Marunouchi**
**Chiyoda-ku Tokyo(JP)**

(72) Inventor: **Yokota, Yuko, C/o Mitsubishi Denki K.K.**
**Computer-seisakusho, No. 325, Kamimachiya Kamakura-shi, Kanagawa-ken(JP)**

(74) Representative: **Lawson, David Glynne et al**
**MARKS & CLERK 57-60 Lincoln's Inn Fieldsids**
**London WC2A 3LS(GB)**

(54) **Apparatus for and method of analyzing coupling characteristics.**

(57) Characteristics of a coupled system, which consists of a plurality of unit structures coupled together, are analyzed accurately and quickly by providing, between calculating means for calculating transfer function matrices concerning unit structures and coupling means for coupling togethe transfer function matrices according to definitions of coupling, co-ordinate conversion means for converting transfer function matrices into those in the overall system.

EP 0 406 020 A2

**APPARATUS FOR AND METHOD OF ANALYZING COUPLING CHARACTERISTICS**

Background of the Invention

[Field of the Invention]

This invention relates to the analysis of characteristics of an overall structure consisting of a plurality of sub structures coupled together and, more particularly, a system for and a method of analyzing characteristics of an overall structure such as a structure vibration simulation system, which analyzes vibrations of a plularity of structures either theoretically by a finite element method utilizing a computer or experimentally by using a conventional FFT analyzer used for vibration analysis and estimates vibration characterisitics of an overall structure obtained by coupling together these structures by using a computer before actually manufacturing such overall structure.

[Description of the Prior Art]

An overall structure characteristics analyzer will now be described in conjunction of a structure vibration simulation system. Computer-aided engineering (CAE), which is adopted in the design of structures, particularly machine structures for performing modeling and simulation of structures with a computer before trial manufacture, has been attracting attention as powerful means for obtaining reduction of development time and cost. In the CAE, vibration analysis is important as a reliability evaluation method in the design of machine structures. As prior art methods of vibration analysis of machine structures, there are an experimental FFT (fast Fourier transform) analysis method and a finite element method as theoretical analysis method. Further, there is a sub structure synthesis method (or a building block approach) as disclosed in Japanese Patent Application 63-060766, in which the experimental FFT analysis and theoretical analysis based on the finite element method are performed with respect to each element (sub structure) of a machine structure for analysis, and the results of the analyses are used to numerically simulate vibration characteristics of the machine structure (overall structure).

In the experimental FFT analysis method, operations of causing vibrations of a machine structure, measuring responses at this time, sampling these signals with an A-D converter, supplying sampled digital data to a minicomputer or microcomputer, performing FFT of these data and producing transfer function between vibration application point and response point, are performed repeatedly for various points of the machine structure, and modal parameters such as peculier vibration frequency of the structure, damping ratio and vibration mode by means of curve fitting (or modal analysis). This method is used as important means for obtaining vibration characteristics of the actual structure.

The finite element method, on the other hand, is a method of theoretical analysis utilizing a computer. In this method, a machine structure is thought to be capable of being expressed by a collection of a finite number of finite elements. Relation between externally applied force and resultant deformation is obtained for each element. These relations are used to define a displacement function concerning the relation between externally applied force to and resultant deformation of the overall machine structure. Using this displacement function, stiffness matrix [K] and mass matrix [M] are obtained to solve a eigen value problem given as

$$[M] \{ \ddot{x} \} + [K] \{x\} = \{0\} \qquad (1)$$

where $\{x\}$ represents a displacement vector, and $\ddot{\phantom{x}}$ a second order time differential. Also, the peculier vibration frequency and vibration mode of the structure are obtained. Further, an equation of motion given as

$$[M] \{ \ddot{x} \} + [C] \{ \dot{x} \} + [K] \{x\} = \{f\} \qquad (2)$$

where [M] represents a mass matrix, [C] an damping matrix, $[C] = \alpha [M] + \beta [K]$, $\alpha$ and $\beta$ damping as ratios, [K] a stiffness matrix, $\{f\}$ external force, $\{x\}$, $\{\dot{x}\}$ and $\{ \ddot{x} \}$ displacement, velocity and acceleration vectors, is solved to obtain response analysis of each method.

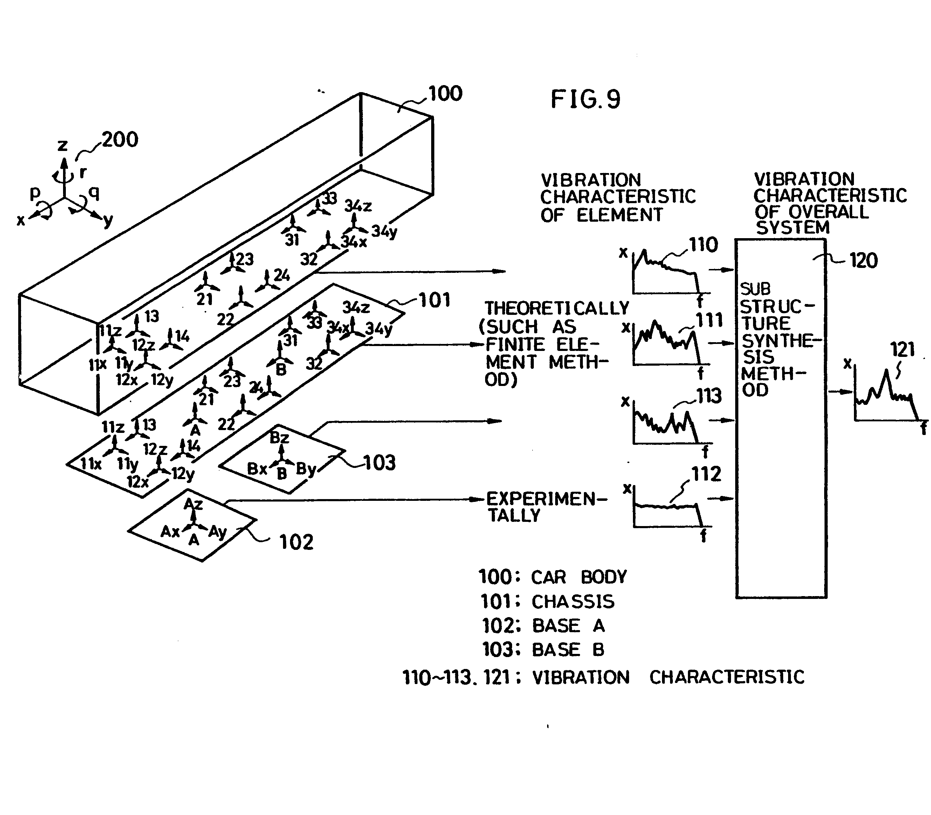

The sub structure synthesis method is one, in which experimental FFT analysis and theoretical analysis based on the finite element method are performed with respect to each element (or sub structure) of the machine structure for analysis, and results of the analyses are numerically simulated. A specific example of this method will now be described with reference to Fig. 9.

2

Fig. 9 illustrates a simulation concerning a railway car design. Referring to the Figure, reference numeral 100 designates car body, 101 chassis, and 102 and 103 local bases A and B. These parts constitute elements of the railway car. Designated at 110 to 113 are examples of vibration characteristic of car body 100, chassis 101 and local bases A 102 and B 103, respectively, 121 an example of vibration characteristic of overall system obtained by sub structure synthesis method 120. In the graphs of the vibration characteristic examples , the ordinate x is taken for vibration response, and the abscissa f for the frequency. Designated at 200 is a co-ordinate system, in which the railway car is found. This co-ordinate system represents a three-dimensional co-ordinate space defined by perpendicular x, y and z axes. Designated at 11 to 14, 21 to 24 and 31 to 34 are points of measurement selected in car body 100 and chassis 101. Designated at A and B are selected points of measurement in chassis 101 and local bases A 102 and B 103. Points of measurement designated by like reference numerals or symbols constitute a point of coupling when the individual elements are coupled together. Generally, vibration response at one point of measurement may be examined by considering the following six different directions as shown in co-ordinate system 200:

(1) Direction (x) of the x axis,
(2) Direction (y) of the y axis,
(3) Direction (z) of the z axis,
(4) Direction (p) of rotation about the x axis,
(5) Direction (q) of rotation about the y axis, and
(6) Direction (r) of rotation about the z axis.

These directions are referred to as degrees of freedome. Thus, there are at most six degrees of freedom at one point of measurement. In a system, in which the directions p, q and r of rotation can be ignored, there are only three degrees x, y and z of freedom. Further, where only a spring undergoes a vertical motion, there is only a single degree of freedom (in the sole direction x, for instance).

Now, the determination of transfer function which is extensively used for analyzing vibration characteristics of elements will be described.

If 12 points 11 to 34 of measurement in car body 100 each have three degrees x to z of freedom, there are a total of $N = 12 \times 3 = 36$ degrees of freedom.

In this way, one or more points of measurement with a total of N degrees of freedom are selected in a structure, with numerals $1, 2, \cdots N$ provided to designate the individual degrees of freedom, and by setting a degree m of freedom to be a direction of response and another degree $l$ of freedom to be a direction of vibration application, vibration of a predetermined waveform (the vibration being expressed as displacement, velocity or acceleration of the pertinent point of measurement) is applied in the direction of vibration application, and vibration in the direction of response is measured.

In this case, the frequency spectrum of vibrations in the direction of vibration application is well known, and as for the frequency spectrum of vibration in the direction of vibration application the vibration transfer function II between the direction $l$ of pressure application and direction m of response can be expressed as function $H_{m,l}(\omega)$ of angular frequency $\omega$ to determine $H_{m,1}(\omega)$, $H_{m,2}(\omega)$, $\cdots$ $H_{m,N}(\omega)$. Further, there are characters that $H_{m,m}(\omega) = 1$ and $H_{m,l}(\omega) = H_{l,m}(\omega)$, which is referred to as theorum of reciprocity.

This transfer function $H_m, \omega$ is set as $N \times N$ matrix to obtain transfer function matrix $(G^{(k)}_{(\omega)}]$

with respect to sub structure, given as

$$
[G^{(k)}_{(\omega)}] =
\begin{bmatrix}
H_{1,1}(\omega) & H_{1,2}(\omega) & \cdots H_{1,l}(\omega) & \cdots H_{1,N}(\omega) \\
H_{2,1}(\omega) & H_{2,2}(\omega) & & \\
H_{m,1}(\omega) & \cdots\cdots\cdots & H_{m,l}(\omega) & \\
H_{N,1}(\omega) & \cdots\cdots\cdots\cdots & & H_{N,N}(\omega)
\end{bmatrix}
\tag{3}
$$

Then, by denoting force $f_l$ applied in each direction $l$ of vibration application, external force vector $F^{(k)}$ with respect to sub structure k in directions 1 to N of vibration application is expressed as

$$\{ F^{(k)} \} = \left\{ \begin{array}{c} f_1 \\ f_2 \\ f_\ell \\ f_N \end{array} \right\} \quad \cdots\cdots\cdots\cdots\cdots\cdots\cdots\cdots\cdots\cdots (4)$$

An equation of motion expressed by transfer function for each local structure is

$[G^{(K)}] \{F^{(k)}\}\{x^{(k)}\}$    (5)

where $\{ F^{(k)} \}$ : is external force vector given to degree of freedom of sub structure k,

$\{ x^{(k)} \}$ : is displacement vector of degree of freedom of sub structure k, and

$( G^{(K)} )$ : is transfer function matrix of sub structure k.

The transfer function calculated here concerns transfer function matrix $[G^{(k)}_{(\omega)}]$

of compliance (displacement/force), and for conversion to transfer function matrix $[H^{(k)}_{(\omega)}]$

of dynamic stiffness (force/displacement), it is converted to transfer function of dynamic stiffness by obtaining inverse matrix by using an equation

$$[H^{(k)}_{(\omega)}] = [G^{(k)}_{(\omega)}]^{-1} \quad \cdots\cdots\cdots\cdots\cdots\cdots\cdots (6)$$

In this way, an equation of motoion given as

$[H^{(k)}_{(\omega)}] \{x^{(k)}\} = \{F^{(k)}\}$    (7)

is given for each local structure.

Now, a method of obtaining an overall system equation by coupling together the individual sub structures will be described.

First, a method of obtaining a system by coupling together two sub structures and producing an equation of motion of the system will be described. Of the two sub structures, the degrees of freedom are classified to be those ($\{x_m^{(1)}\}$, $\{x_m^{(2)}\}$) where a further sub structure is coupled and those ($\{X_r^{(1)}\}$, $\{X_r^{(2)}\}$) where no further sub structure is coupled. For example, $X_m^{(1)}$ and $X_m^{(2)}$ may be thought to be the degrees of freedom of points of measurement which show the same response when and only when sub structures are coupled together by bolting. Equations of motion of individual sub structures are given as

4

$$\begin{bmatrix} H_{rr}^{(1)}(\omega) & H_{rm}^{(1)}(\omega) \\ H_{mr}^{(1)}(\omega) & H_{mm}^{(1)}(\omega) \end{bmatrix} \begin{Bmatrix} X_r^{(1)} \\ X_m^{(1)} \end{Bmatrix} = \begin{Bmatrix} F_r^{(1)} \\ F_m^{(1)} \end{Bmatrix} \quad \cdots (8)$$

$$\begin{bmatrix} H_{mm}^{(2)}(\omega) & H_{mr}^{(2)}(\omega) \\ H_{rm}^{(2)}(\omega) & H_{rr}^{(2)}(\omega) \end{bmatrix} \begin{Bmatrix} X_m^{(2)} \\ X_r^{(2)} \end{Bmatrix} = \begin{Bmatrix} F_m^{(2)} \\ F_r^{(2)} \end{Bmatrix} \cdot \quad \cdots (9)$$

When $\{X_m^{(1)}\}$ and $\{X_m^{(2)}\}$ are coupled together, the equation of motion of the individual sub structures are now

$$\begin{bmatrix} H_{rr}^{(1)}(\omega) & H_{rm}^{(1)}(\omega) \\ H_{mr}^{(1)}(\omega) & H_{mm}^{(1)}(\omega) \end{bmatrix} \begin{Bmatrix} X_r^{(1)} \\ X_m^{(1)} \end{Bmatrix} = \begin{Bmatrix} F_r^{(1)} \\ F_m^{(1)} - p \end{Bmatrix} \quad \cdots (10)$$

$$\begin{bmatrix} H_{mm}^{(2)}(\omega) & H_{mr}^{(2)}(\omega) \\ H_{rm}^{(2)}(\omega) & H_{rr}^{(2)}(\omega) \end{bmatrix} \begin{Bmatrix} X_m^{(2)} \\ X_r^{(2)} \end{Bmatrix} = \begin{Bmatrix} F_m^{(2)} + p \\ F_r^{(2)} \end{Bmatrix} \quad \cdots (11)$$

where $\{P\}$ represents force applied by sub structure 1 to sub structure 2 and $\{-p\}$ represents force applied by sub structure 2 to sub structure 1. By removing p by using equaitons (7) and (11) and a coupling condition

$$\{X_m^{(1)}\} = \{X_m^{(2)}\} \; (=x_m\}) \qquad (12)$$

we obtain

$$\begin{bmatrix} H_{rr}^{(1)}(\omega) & H_{rm}^{(1)}(\omega) & 0 \\ H_{mr}^{(1)}(\omega) & H_{mm}^{(1)}(\omega) + H_{mm}^{(2)}(\omega) & H_{mr}^{(2)}(\omega) \\ 0 & H_{rm}^{(2)}(\omega) & H_{rr}^{(2)}(\omega) \end{bmatrix}$$

$$\begin{Bmatrix} X_r^{(1)} \\ X_m \\ X_r^{(2)} \end{Bmatrix} = \begin{Bmatrix} F_r^{(1)} \\ F_m \\ F_r^{(2)} \end{Bmatrix} \qquad \cdots \cdots \cdots \cdots \cdots \cdots \cdots (13)$$

This equation is an equaiton of motion of the system obtained by coupling together the two sub structures. Here, $\{F_m\}$ is $\{F_m\} = \{F_m^{(1)}\} + \{F_m^{(2)}\}$ and represents external force acting on coupling point $\{X_m\}$. The method of producing the equation of motion of the system obtained by coupling together two sub structures can be seen by regarding the coefficient matrix of equation (13) as

$$\left[ \begin{array}{cc} H_{rr}^{(1)}(\omega) & H_{rm}^{(1)}(\omega) \\ H_{mr}^{(1)}(\omega) & H_{mm}^{(1)}(\omega) \\ & 0 \end{array} \quad + \quad \begin{array}{cc} & 0 \\ H_{mm}^{(2)}(\omega) & H_{mr}^{(2)}(\omega) \\ H_{rm}^{(2)}(\omega) & H_{rr}^{(2)}(\omega) \end{array} \right]$$

sub structure 1          sub structure 2

Coupling between sub structures 1 and 2

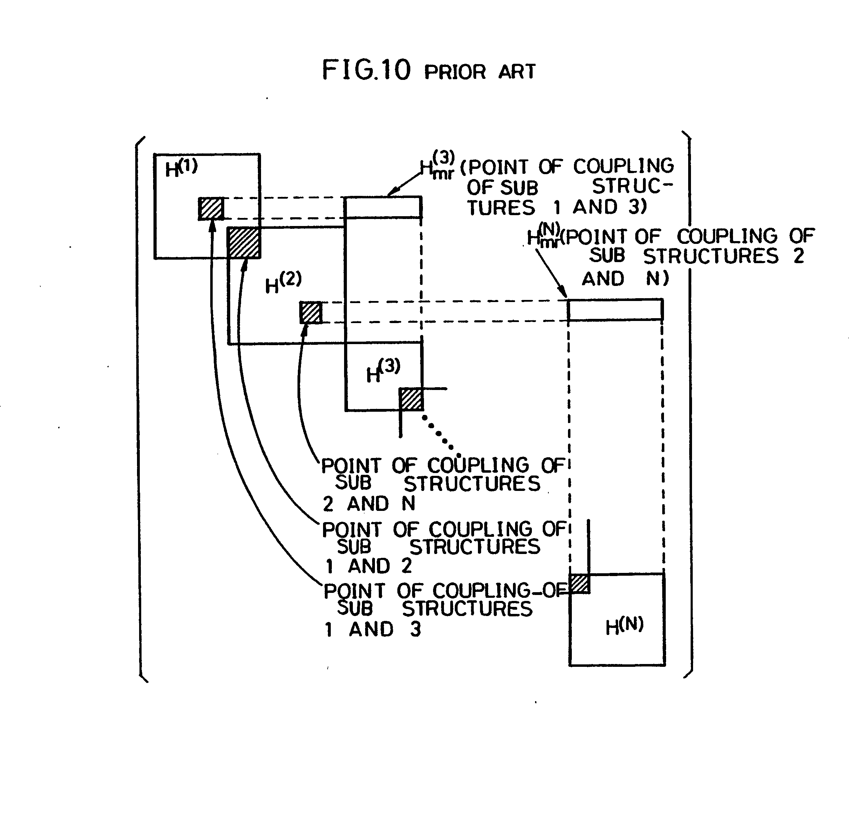

An equation of the overall system is produced by coupling together sub structures in the method described above in the order of input of the sub structures. When the overall system is produced by coupling together N sub structures $[H(\omega)]$ of the system is as shown in Fig. 10.

In this way, we obtain the equation of the overall system as

$[H(\omega)] \{x\} = \{F\}$     (14)

This equation is applied in case where a degree of freedom provides response independent of other degrees of freedom. Actually, there is a case where a certain degree of freedom is depend to a different degree of freedom. This relation is referred to as restrictive relation of degrees of freedom.

This constraint relation will now be described with reference to Fig. 9. When there is a vibration in x direction of point A of measurement (i.e., Ax direction) and also there is vibration response in x direction at point 11 of measurement (i.e., 11x direction), Ax is referred to as independent degree of freedom, and 11x is dependent degree of freedom. The constraint relation in this case is 12 times.

Concerning such constraint relation a constraint relation matrix $[\Gamma]$ is produced. Denoting displacement vector of an independent degree of freedom as $\{x_i\}$ and displacement vector of a dependent degree of freedom as $\{x_d\}$ , we have

$\{X_d\} = [\Gamma] \{x_i\}$     (15)

as constraint relation equation.

Thus, it is necessary to substitute this constraint relation into overall system equation (14) to obtain correct simulation of response. Before describing a method of substitution of the constraint relation into the overall system equation, a way of thinking of co-ordinate conversion utilizing this constraint relation will be described.

The introduction of the constraint relation as noted above is used in case where there is a dependent relation among the degrees of freedom of the total structure. Heretofore, this constraint is utilized for the co-ordinate conversion to be described later.

In the conventional sub structure synthesis method, if a co-ordinate space for analyzing sub structure data by the finite element method or experimental FFT analysis and co-ordinate space where the overall structure is placed are different from each other, the co-ordinate space when performing the sub structure analysis and co-ordinate space where the overall structure is placed are relatred to each other by using the constraint relation among degrees of freedom. For example, data obtained by measuring a certain sub structure with a certain co-ordinate system, can not be used directly if the co-ordinate system is different from the co-ordiante system of the overall structure including the sub structure. For example, when data is obtained with the sub structure held in a horizontal state and the sub structure is coupled at an angle of 45 degrees, it is necessary to convert the data to those in case where the sub structure is at an angle of 45 degrees.

An noted before, the displacement vector $\{x_i\}$ of independent freedom degree at the time of the sub structure analysis and displacement vector $\{X_d\}$ of dependent freedom degree of the local structure in the co-ordinate space where the overall structure is placed are related using constraint relation matrix $[\Gamma]$ as

$\{x_d\} = [\Gamma] \{x_i\}$     (16)

It is noted before that $[\Gamma]$ is given absolutely by the relation between $\{X_i\}$ and $\{X_d\}$ $\{X_i\}$ in equation (16) are in a constraint relation among degrees of freedom. Into this constraint relation, the constraint relation of points and positional relation of co-ordinate systems for co-ordinate conversion are substituted.

Now, a method of substituting this constraint relation matrix $[\Gamma]$ into the overall system equation will be described.

In the sub structure synthesis method, the constraint relation is applied to overall system equation (14) as follows.

First, displacement vectors $\{x\}$ of freedom degrees of the overall system are divided into $\{x_d\}$ , $\{x_i\}$ and $\{x_r\}$ , that is,

$$\{x\} = \left\{ \begin{array}{c} x_d \\ x_i \\ x_r \end{array} \right\} \quad \cdots\cdots(17)$$

Here, $\{x_r\}$ represents degrees of freedom which do not appear in constraint relation equation (16). With this division of freedom degrees, equation (14) is changed to

$$\left[ \begin{array}{ccc} H_{dd} & H_{di} & H_{dr} \\ H_{id} & H_{ii} & H_{ir} \\ H_{rd} & H_{ri} & H_{rr} \end{array} \right] \left\{ \begin{array}{c} x_d \\ x_i \\ x_r \end{array} \right\} = \left\{ \begin{array}{c} F_d \\ F_i \\ F_r \end{array} \right\} \quad \cdots\cdots(18)$$

Constraint relation equation (16) means that restrictive forces $\{p_r\}$ and $\{p_i\}$ act on $\{x_i\}$ and $\{x_m\}$ . Thus, when there is a constraint relation, the overall system equation is given as

$$\left[ \begin{array}{ccc} H_{dd} & H_{di} & H_{dr} \\ H_{id} & H_{ii} & H_{ir} \\ H_{rd} & H_{ri} & H_{rr} \end{array} \right] \left\{ \begin{array}{c} x_d \\ x_i \\ x_r \end{array} \right\} = \left\{ \begin{array}{c} F_d + P_d \\ F_i + P_i \\ F_r \end{array} \right\} \quad \cdots\cdots(19)$$

$\{P_d\}$ and $\{P_i\}$ are related as
$$\{P_i\} = - [\Gamma] \{P_d\} \quad (20)$$

By using this relation, equation (19) is changed to

$$\left[ \begin{array}{cccc} H_{dd} & H_{di} & H_{dr} & -I \\ H_{id} & H_{ii} & H_{ir} & \Gamma^T \\ H_{rd} & H_{ri} & H_{rr} & 0 \end{array} \right] \left\{ \begin{array}{c} x_d \\ x_i \\ x_r \\ P_d \end{array} \right\} = \left\{ \begin{array}{c} F_d \\ F_i \\ F_r \end{array} \right\} \quad \cdots\cdots(21)$$

(I representing unit matrix, and T represents transposed). This equation is combined with equation (16) to obtain an overall system equation including constraint relation as

$$\left[ \begin{array}{cccc} H_{dd} & H_{di} & H_{dr} & -I \\ H_{id} & H_{ii} & H_{ir} & \Gamma^T \\ H_{rd} & H_{ri} & H_{rr} & 0 \\ -I & \Gamma & 0 & 0 \end{array} \right] \left\{ \begin{array}{c} X_d \\ X_i \\ X_r \\ P_d \end{array} \right\} = \left\{ \begin{array}{c} F_d \\ F_i \\ F_r \\ 0 \end{array} \right\} \quad \cdots\cdots(22)$$

The vibration characteristics of the overall structure can be analyzed by solving this equation (22).

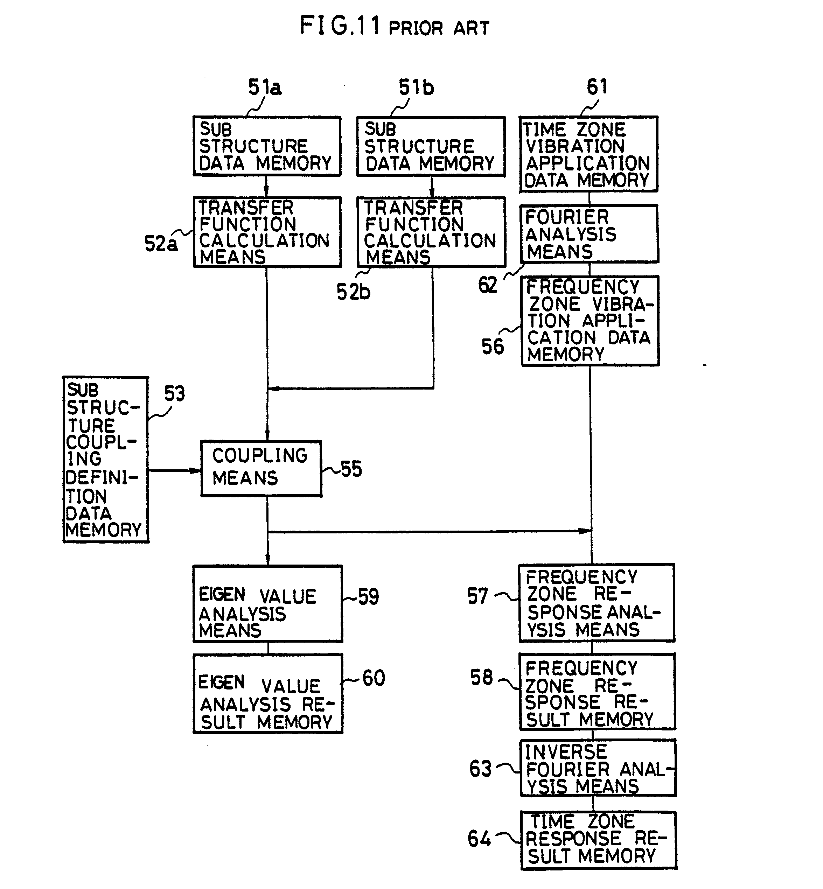

Fig. 11 is a block diagram showing a prior art example of structural vibration simulation system. Referring to the Figure, designated at 51a and 51b are sub structure data memories for storing data of first and second sub structures, at 52a and 52b transfer function calculation means for calculating transfer function matrices of structure from sub structure data from sub structure data memories 51a and 51b (i.e., sub structure data obtained by measuring or analytically estimating vibrations of the first and second sub structures), at 53 sub structure coupling definition data memory for storing coupling conditions indicative of whether coupling is rigid or soft, constraint relation matrices representing constraint relations of individual degrees of freedom and co-ordinate conversion matrices overlapping the constraint relation matrices, and at 55 coupling means for coupling transfer function matrices of the first and second structures obtained from transfer function calculation means 52a and 52b to sub structure coupling definition data memory 53 in accordance with a predetermined coupling condition to produce a transfer function matrix of the overall structure after coupling.

Designated at 59 is eigen value analysis means for analyzing eigen mode and mode shape of the overall structure after coupling with transfer function matrix data from coupling means 55, at 60 a eigen value analysis result memory for storing analysis results obtained from eigen value analysis means 59, at 61 time zone vibration application data memory for strong time zone vibration application data of structure, and at 62 Fourier analysis means for Fourier analysis converting the time zone vibration application data into frequency zone vibration application data for analysis in frequency zone.

Designated at 56 is frequency zone vibration application data memory for strong frequency zone vibration application data obtained from Fourier analysis means, at 57 frequency zone response analysis means for analyzing response in frequency zone at each point of the structure after coupling with transfer function matrix data from coupling means 55 and frequency zone vibration application data from Fourier analysis means 62 (i.e., frequency zone vibration application data from frequency zone vibration application data memory 56), and at 50 frequency zone response result memory for storing frequency zone response analysis results obtained from frequency zone response analysis means 57.

Designated at 63 is inverse Fourier analysis means for converting frequency response analysis results obtained from frequency zone response analysis means 57 (i.e., contents of frequency zone response result memory 58) into time zone response analysis results, and at 64 a time zone response result memory for storing the time zone response analysis results.

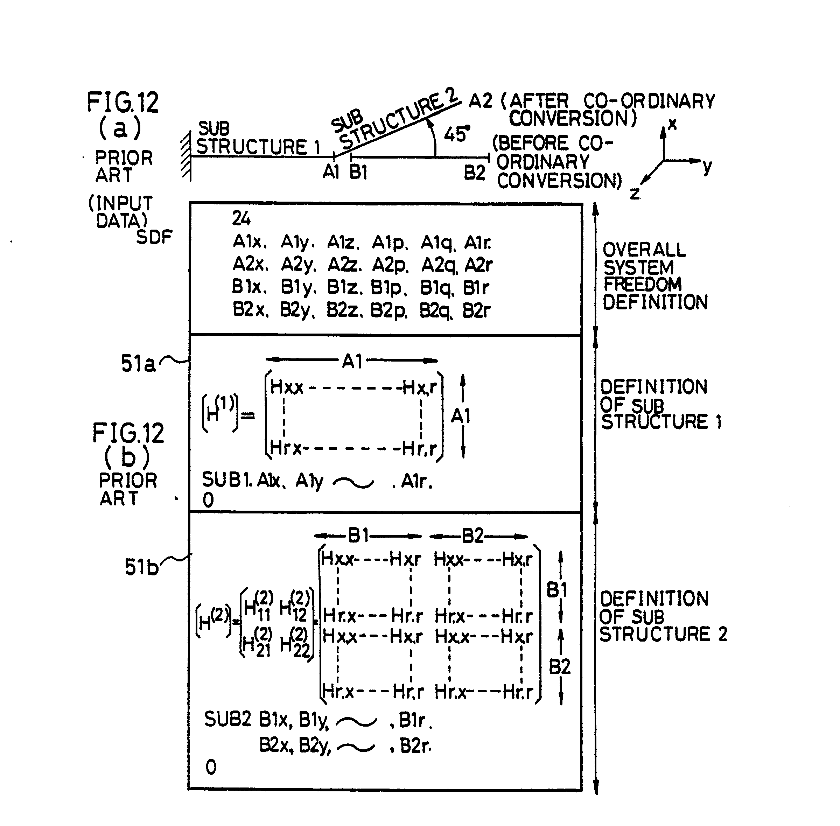

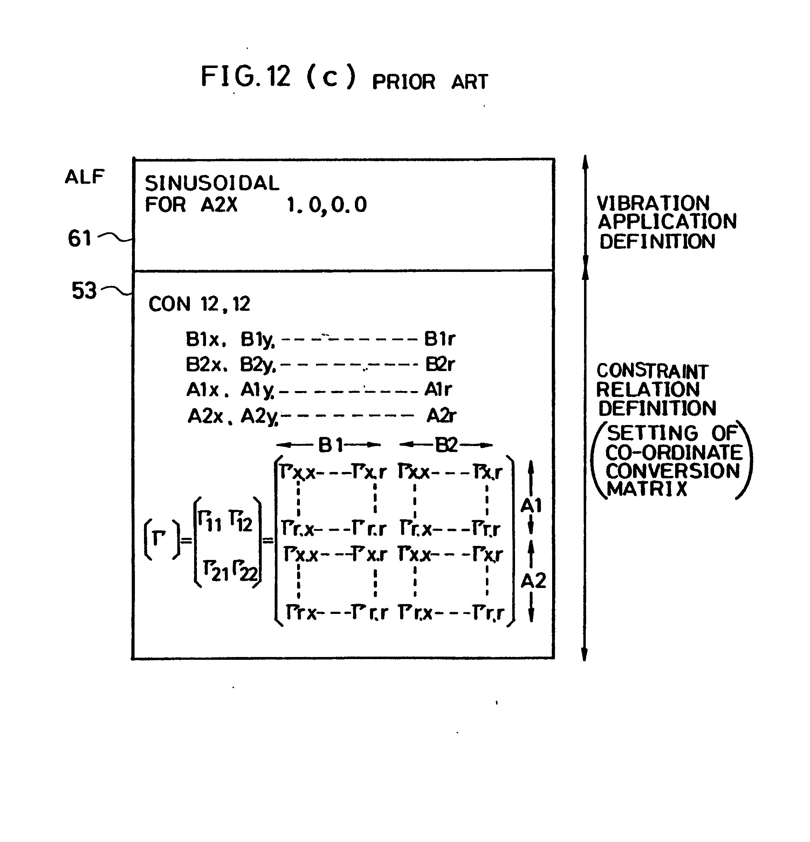

Now, prior art example will be described with reference to Figs. 12(a) to 12(c). Fig. 12(a) is a schematic view showing overall structure consisting of sub structure 1 and 2. Sub structure 1 is a cantilever structure secured at one end to a wall and having point A1 of measurement at the other end. Sub structure 2 is a free-free beam structure with the opposite ends measured at points B1 and B2 of measurement and coupled to sub structure 1 in a state A1-A2 at an angle of 45 degrees in x direction. Fig. 12(b) shows a system definition file (SDF) as an example of sub structure data memory 51a and 51b. In this file, the degrees of freedom of the overall system and sub structures 1 and 2, as shown at 51a and 51b, are defined. There are 24 definitions of freedom degrees for the overall system. This is so because there are six degrees (x to z and p to r) of freedom at each of four points A1, A2, B1 and B2 of measurement. In sub structure 1 definition file 51a, data for transfer function matrix $[H^{(1)}]$ for the six degrees of freedom at point A1 of measurement of sub structure 1 are stored. In sub structure 2 definition file 52b, data for transfer function matrix $[H^{(2)}]$ for a total of 12 degrees of freedom at points B1 and B2 of measurement are stored.

Fig. 12(c) shows a vibration application constraint data file (ALF) as an example of frequency zone vibration application data memory 56 and sub structure coupling definition data memory 53. This file includes file 61 for storing definitions of the kind and size of forces applied and file 53 for defining constraint relation including co-ordinate conversion.

Definition file 61 represents obtaining frequency response (SINUSOIDAL) when external force with amplitude of 1.0 and phase of 0.0 degree is applied to freedom degree A2x (x direction at point A2 of measurement).

In constraint relation definition file 53, the number n of independent degrees of freedom and number m of dependent degrees of freedom are defined in CON n, m and are sequentially listed. In this exmaple, 12 freedom degrees B1a to B2x are independent, and freedom degrees A1x to A2x are dependent. Dependance relation is shown such that A1x is depend to B1a, A1y to B1y and so forth. In this way, it is shown here that the six degrees of freedom at point B1 of measurement are all subordinate to six degrees of freedom at point A1 of measurement, indicating rigid coupling at these points. Regarding [Γ], while sub structure 2 is held for measurement in horizontal state (B1-B2), it is coupled to sub structure 1 in inclined state (A1-A2) at an angle of 45 degrees with respect to x direction, its co-ordinate conversion matrix is entered using the intrinsic constraint relation.

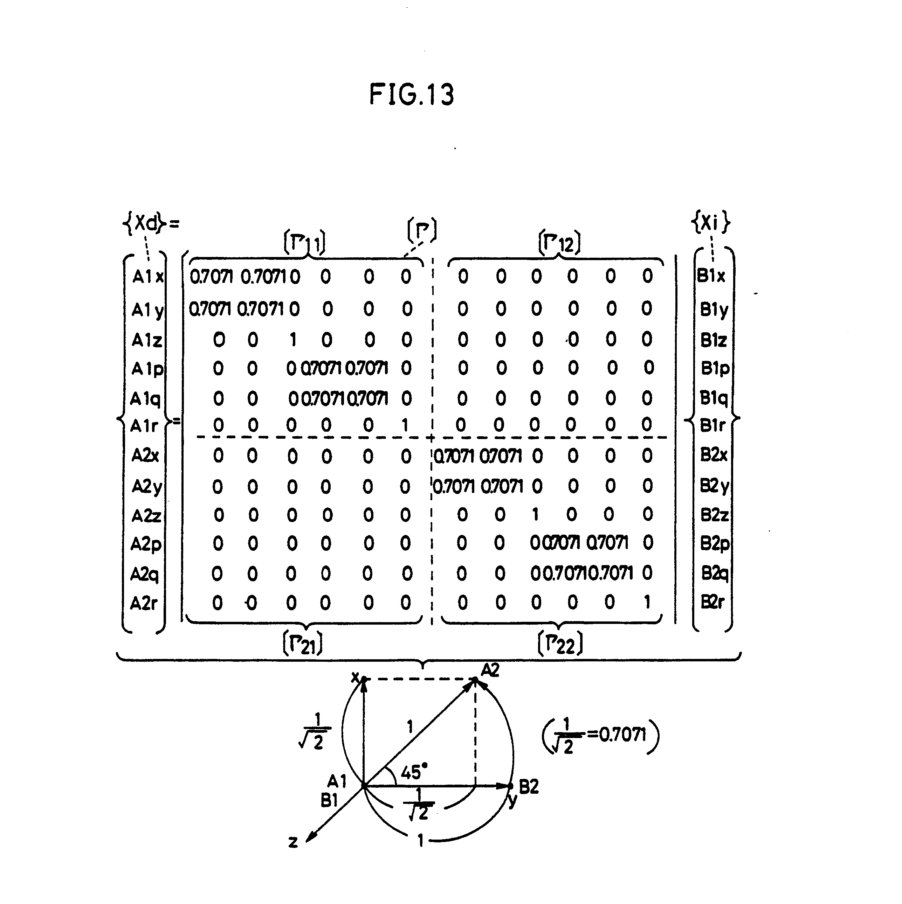

Fig. 13 shows the constraint relation. Constraint relation matrix [1] does not contain any real constraint relation but includes only co-ordiante conversion matrix. For example, considering the degrees of freedom in x to z direction at A2,

A 2 x = 0.7071 B 2 x + 0.7071 B 2 y     (23)

A 2 y = 0.7071 B 2 x + 0.7071 B 2 y     (24)

A 2 z = B 2 z     (25)

It will be seen that the degrees of freedom in x to z directions at B2 are converted to the degrees of freedom in x to z directions at A2.

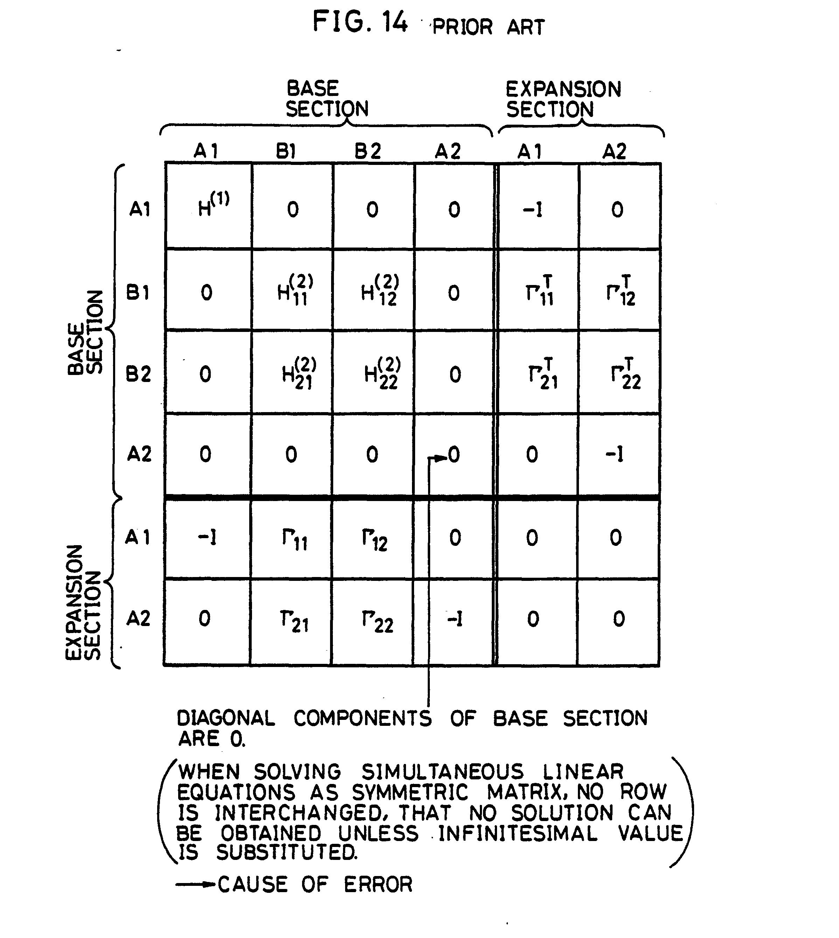

Fig. 14 shows the transfer function matrix of the overall system produced on the basis of a model as shown in Fig. 12. In the Figure, like reference sysmbols designate like or corresponding parts. Designated at I is a unit matrix. Referring to the Figure, a basic section is a matrix formed with respect to all (24) degrees of freedom defined by the overall system freedom degree definitions in SDF. The matrix components in A2 portion of the basis section are all "0" because there is no data concerning A2 portion in the definitions of sub structures 1 and 2 in SDF. More specifically, sub structure 2 is held in horizontal state (B1-B2) for measurement, while no data at A2 after the coupling is present in the definitions of the sub structures.

Since A1 and B1 are coupled together, H $^{(1)}$ + H $^{(2)}$ should be calculated as in equation (15). However, since their co-ordinate systems are different, the two can not be simply added, and they have to be held as separate elements.

In an expanded section, 12 dependent degrees of freedom at A1 and A2 are arranged such that [$\Gamma$] where the constraint relation matrix of B1 and B2 is arranged as in equation (22). (By interchanging the rows and columns in Fig. 11 the same form as in equation (22) is obtained.

As shown, the matrix even of a simple setting as shown in Fig. 12(a) is a matrix of 36 by 36 degrees of freedom, and its solution takes long calculation time.

As is shown, the prior art method using the constraint relation equation is used when the degrees of freedom of the entire structure involve a dependent relation (i.e. when a motion of a degree of freedom depends on a motion of a different degree of freedom. In other words, no dependent relation of the entire degrees of freedom of a certain sub structure to the entire degrees of freedom of a different sub structure is defined.

However, when this method is used for the conversion of the co-ordinate system of a sub structure to the co-ordinate system of the overall structure as noted above, for co-ordiante conversion of one of two sub structures as shown in Fig. 12(a), the overall system equation is, from equation (22),

$$
\begin{pmatrix}
0 & 0 & 0 & -I \\
0 & H_{ii} & 0 & \Gamma^T \\
0 & 0 & H_{rr} & 0 \\
-I & \Gamma & 0 & 0
\end{pmatrix}
\begin{pmatrix}
X_d \\
X_i \\
X_r \\
P_d
\end{pmatrix}
=
\begin{pmatrix}
F_d \\
0 \\
F_r \\
0
\end{pmatrix}
\quad \cdots (26)
$$

where [$H_{ii}$] : represents a transfer function matrix [H $^{(2)}$] requiring co-ordiante conversion,

[$H_{rr}$] : a transfer function matrix H $^{(1)}$ requiring no co-ordinate conversion,

[$\Gamma$] : a constraint relation matrix for co-ordinate conversion,

{$X_d$} : a displacement vector of freedom degree after co-ordinate conversion,

{$X_i$} : a displacement vector of freedom degree before co-ordinate conversion,

{$X_r$} : other displacement vector of freedon degree,

{$F_d$} : an external force vector of freedom degree as subject of co-ordinate conversion, and

{$F_r$} : other external force vector of freedom degree.

Generally, the transfer function matrix [H] of the overall structure in the overall system equation given as [H] {X} = {f}     (27)

is a symmetrical matrix.

Thus, when solving equation (27) using a computer, solution of [M] as symmetrical matrix requires only one half of memory and is efficient. For this reason, this method is used boardly.

However, in the solution of simultaneous equations of a symmetrical matrix can not permit such process as interchange of rows. For this reason, a sweep-out process is adopted with the diagonal components of matrix as main point. In the solution of simultaneous linear equations of a symmetrical matrix where 0 is present, a small value $\epsilon$ (minimum value of the calculation accuracy) is added to permit affine solution of the equations. However, this small value $\epsilon$ is liable to influence the accuracy of the solution.

Therefore, when performing co-ordinate conversion of a sub structure, the method of solving equation (26) using a constraint relation is liable that the diagonal components of a portion

$$\begin{pmatrix} 0 & 0 & 0 \\ 0 & H_{ii} & 0 \\ 0 & 0 & H_{rr} \end{pmatrix}$$

in the basic section of the equation include 0. For this reason, higher accuracy can be obtained by solving the equation not as symmetrical matrix but as complete matrix. When conventional constraint relation equations are used for co-ordinate conversion of a sub structure, the following problems.

(1) When simultaneous linear equations are solved as symmetrical matrix, no solution or merely approximate solution can be obtained.

(2) When the equations are solved as complete matrix, enormous memory capacity is necessary.

(3) Of the freedom degrees concerning co-ordinate conversion among the freedom degrees of the structure, those both before and after coordinate conversion are recognized. Therefore, the degrees of freedom are increased that much, and this means memory capacity increase.

(4) The equation scale is increased to increase time required for solving the equations.


## Summary of the Invention


An object of the invention is to provide a system for analyzing characteristics of an overall structure, which necessary calculation time and memory capacity are greatly reduced compared to the prior art method of expressing information concerning co-ordinate conversion for each sub structure as constraint relation equation based on the sub structure synthesis method and is substituted into overall system equation to obtain solution, and which permits design efficiency increase and accuracy improvement and stabilization of solution.


## Brief Description of the Drawings


Fig. 1 is a block diagram showing a structure vibration simulation system as an embodiment of the invention;

Fig. 2 is a block diagram showing a structure vibration simulation system as an embodiment of the invention;

Fig. 3 is a view showing an example of sub structure combination;

Fig. 4 is a view showing Euler angle;

Fig. 5 is a flow chart illustrating the operation of co-ordinate conversion means;

Fig. 6 is a view for explaining definition contents of an embodiment of the invention;

Fig. 7 is a view showing an overall system transfer function matrix in an embodiment of the invention;

Fig. 8 is a flow chart for explaining the operation of the structure vibration simulation system as embodiment of the invention;

Fig. 9 is a view for explaining simulation of a railway car;

Fig. 10 is a view illustrating a method of coupling transfer function matrices;

Fig. 11 is a block diagram showing a structure vibration simulation system based on a prior art sub structure synthesis method;

Fig. 12 is a view for various definition contents of explaining a structure vibration simulation system based on a prior art structure synthesis method;

Fig. 13 is a view showing a constraint function matrix based on the prior art sub structure synthesis method; and

Fig. 14 is a view showing an overall system transfer function matrix based on prior art sub structure synthesis method.

## Description of the Preferred Embodiments

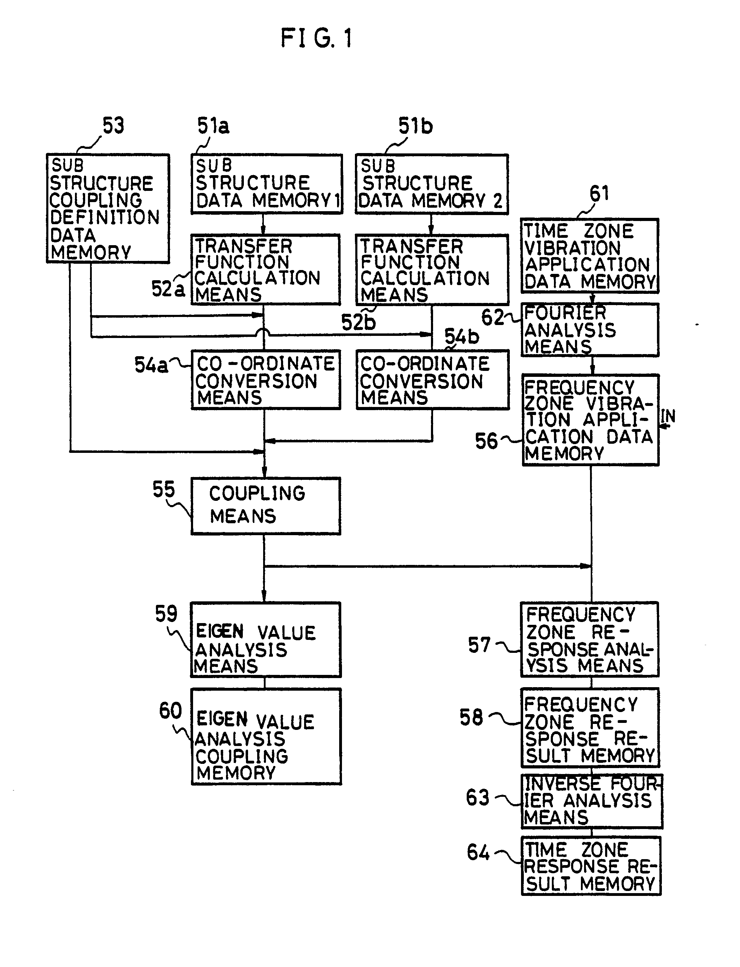

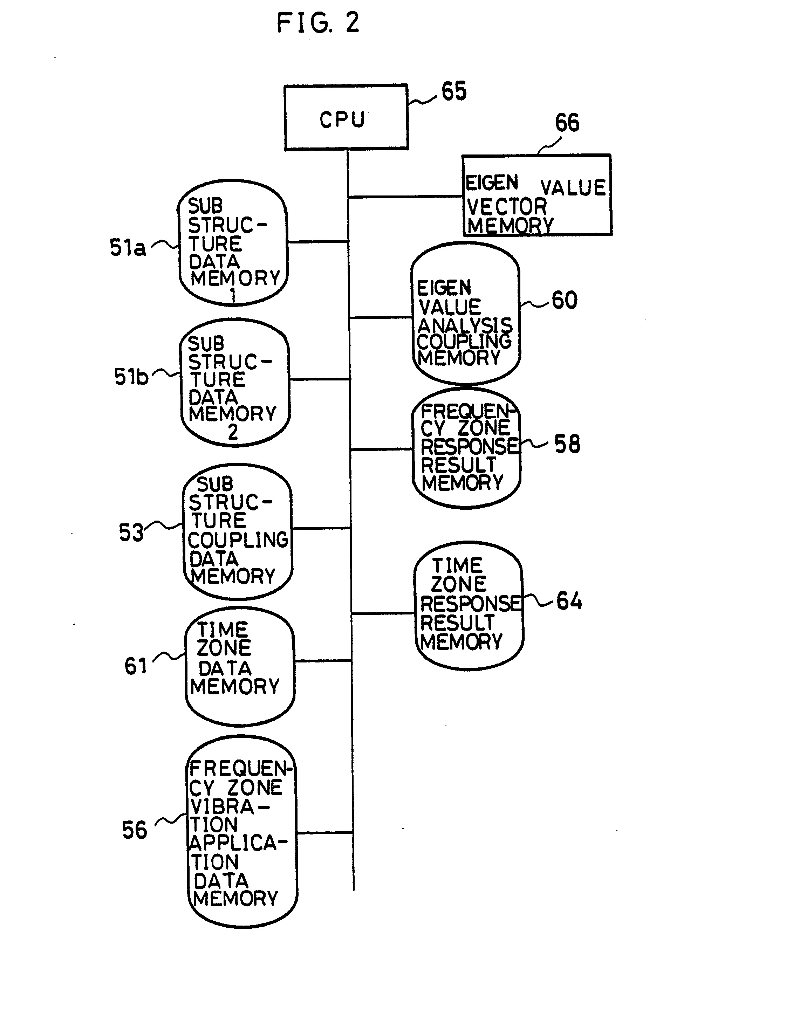

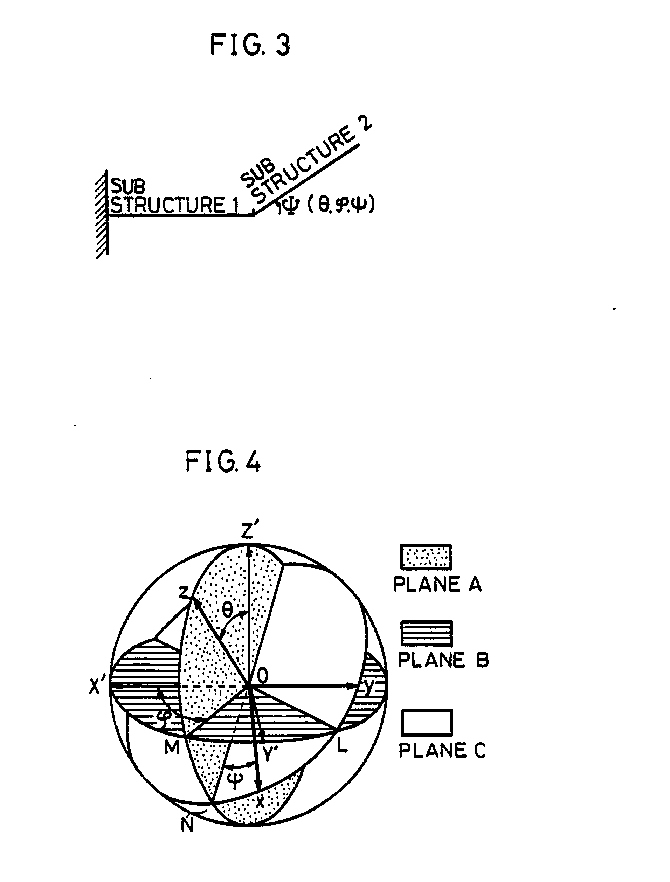

Figs. 1 and 2 are block diagrams showing the functions and construction of a structure vibration simulation system as one embodiment of the invention. Referring to the Figures, designated at 51a and 51b are sub structure data memories for storing sub structure data of first and second sub structures, at 52a and 52b transfer function calculating as an example of response characteristics calculating means for calculating a transfer function matrix of structure from sub structure data from sub structure data memories 51a and 51b (i.e., sub structure data obtained by measuring or analytically estimating vibrations of the first and second structures of Fig. 3), at 53 a sub structure coupling data definition data memory as an exmaple of data storage means for providing positional relations of the co-ordiantes of the first and second structures to an overall sysem co-ordiante system as co-ordiante conversion data in terms of Euler's angles ( $\theta$, $\phi$ and $\psi$) of three-dimensional co-ordinate conversion and storing coupling definition data specifying a method of coupling of the first and second structures as rigid coupling of degrees of freedom (common use of degrees of freedom) or soft coupling (coupling by spring and damper), at 54a and 54b co-ordinate conversion means for producing a three-dimensional co-ordinate conversion matrix from positional relation of co-ordinates provided by the Euler's angles $\theta$, $\phi$ and $\psi$ of the three-dimensional co-ordiante conversion and converting transfer function matrix obtained by transfer function calculating means to transfer function matrix in overall system co-ordinate system, at 55 coupling means for coupling together transfer function matrices of the first and second structures obtained by transfer function calculating means 52a and 52b according to coupling conditions determined by coupling definition data stored in sub structure coupling definition data memory 53 to produce a transfer function matrix of a couploed structure, at 59 eigen value analysis means for analyzing the eigen mode and mode shape of the coupled structure with transfer function matrix from coupling means 55, at 60 a eigen value analysis result memory for storing analysis results obtained by eigen value analysis means 59, at 61 time zone vibration application data memory for storing vibration application data of structure in time zone, at 62 Fourier analysis means for converting the time zone vibration application data by Fourier analysis to frequency zone vibration application data for analysis of the frequency zone, at 56 frequency zone vibration application data memory for storing frequency zone vibration application data obtained from the Fourier analysis means or supplied directly, at 57 frequency zone response analysis means for analyzing the response of the coupled structure at each point thereof in frequency zone from transfer function matrix from coupling means 55 and frequency zone vibration application data from Fourier analysis means 62 or supplied directly (i.e., frequency zone vibration application data from frequency zone vibration data memory 56), and at 58 a frequency zone response result memory for storing frequency zone response results obtained from frequency zone response analysis means 57, at 63 inverse Fourier analysis means for converting frequency response analysis results obtained from frequency zone response analysis means 57 (i .e., contents of frequency zone response reuslt memory 58), and at 64 a time zone response result memory for storing the time zone response analysis results. Referring to Fig. 2, designated at 65 is a CPU, which has functions of the individual means noted above and controls the memories and main storage means 66 for data processing.

Now, functions of main means in this embodiment will be described.

Transfer function calculating means 52a and 52b determine transfer function matrices for individual elements using data obtained by experimental FFT analysis or finite element method analysis. This method of calculation is of the following five types depending on the kind of sub structure data. The transfer function that is determined is of two kinds, i.e., transfer function matrix [G] of compliance (displacement/force) and transfer function matrix H of dynamic stiffness (force/displacement). Where the transfer function matrix [G] of compliance is calculated in the following method, inverse matrix is obtained and is converted to the transfer function of dynamic stiffness as shown by

$$[H] = [G]^{-1} \quad (51)$$

Following equations (52) to (66) show respective types of transfer function calcuating means.

(a) Direct matrix input type

$$[H(\omega)] =$$
$$(-\omega^2[M] + j \omega [C] + [K]) \quad (52)$$
$$[H(\omega)] =$$
$$(-\omega^2[M] + j [B] + [K]) \quad (52)$$

where $\omega$ : represents angular frequency,

[M] : mass matrix,

[K] : stiffness matrix,
[C] : viscosity damping matrix, and
[B] : structure damping matrix.
(b) Non-constraint mode synthesis type (real mode)

$$[G(\omega)] = -\frac{[Y]}{\omega^2} + \sum_{r=1}^{n}$$

$$\frac{\{\psi_r\}\{\psi_r\}^T}{m_r(-\omega^2 + j\omega\zeta_r\omega_r + \omega_r^2)} + [Z] \cdots (54)$$

$$[G(\omega)] = -\frac{[Y]}{\omega^2} + \sum_{r=1}^{n}$$

$$\frac{\{\psi_r\}\{\psi_r\}^T}{m_r(-\omega^2 + jg_r\omega_r^2 + \omega_r^2)} + [Z] \cdots (55)$$

where, $\omega$ : represents angular frequency,
n : mode number,
$m_r$ : modal mass (r = 1 to n),
$\omega_r$ : characteristic frequency (r = 1 to n),
$\{\psi_r\}$ : mode vector in mode r (r = 1 to n),
$\zeta_r$ : mode viscous damping ratio in mode r(r = 1 to n),
$g_r$ : structure damping ratio in mode r (r = 1 to n),
[Y] : residual mass matrix, and
[Z] : residual stiffness matrix.
(c) Non-restrictive mode synthesis type (complex mode)

$$[G(\omega)] = -\frac{[Y]}{\omega^2} + \sum_{r=1}^{n}$$

$$\{\frac{\{\psi_r\}\{\psi_r\}^T}{a_r(j\omega - P_r)} + \frac{\{\bar{\psi}_r\}\{\bar{\psi}_r\}^T}{\bar{a}_r(j\omega - \bar{P}_r)}\}$$

$$(- \text{ representing conjugate}) \cdots\cdots (56)$$

$$[G(\omega)] = -\frac{[Y]}{\omega^2} + \sum_{r=1}^{n}$$

$$\frac{\{\psi_r\}\{\psi_r\}^T}{m_r(-\omega^2 + jg_r\omega_r^2 + \omega_r^2)} + [Z] \cdots (57)$$

where, $\omega$ : represents angular frequency,
n : mode number,
$a_r$ : residue (complex value) in mode r,
$P_r$ : complex eigen value in mode r,
$m_r$ : mode mass in mode r,
$g_r$ : mode structure damping ratio in mode r, $\omega_r$

$\omega_r$ : complex eigen value in mode r,

$\{\psi_r\}$ : complex mode vector in mode r,

[Y] : complex regidual mass matrix, and

[Z] : complex regidual stiffness matrix.

(d) Transfer function synthesis type

Rational expression of [G ($\omega$)] = Rational expression of (j $\omega$)     (58)

Rational expression of [H ($\omega$)] = Rational expression of (j $\omega$)     (59)

(e) Scale element H ($\omega$) = - $\omega^2$ m (m : scalar mass)     (60)

H ($\omega$) = j $\omega$ c (c: ground scalar viscosity damping)     (61)

H ($\omega$) = j $\omega$ [$^c_c$ $^{-c}_c$] (c : scalar viscosity damping among degrees of freedom)     (62)

H ($\omega$) = j b (b : ground structure damping)     (63)

H ($\omega$) = j [$^b_b$ $^{-b}_b$] (b : scalar structure damping)     (64)

H ($\omega$) = k (k : ground scalar stiffness)     (65)

[H ($\omega$) ] = [$^k_k$ $^{-k}_k$] (k : scalar stiffness among degrees of freedom)     (66)

Fig. 3 shows an example of sub structure coupling. Here, the coupling angle is $\Psi$.

In the method of sub structure analysis, a sub structure analysis obtained by analysis for a sub structure unit after another (expressed by mode data, MKC matrices, transfer function matrices, etc.) is synthesized, and characteristics of the overall structure is estimated.

Characteristics of sub structure are analyzed in a co-ordinate system under certain conditions and are not always identical with the co-ordinate system of the overall system. Accordingly, when coupling together structure with certain three-dimensional angles $\Psi$ ($\theta$, $\phi$, $\psi$), it is necessary to perform co-ordinate conversion from each co-ordinate system under analysis into the co-ordinate system of the overall system.

The co-ordinate conversion of the local structure is defined as follows.

(1) Local co-ordinates in the neighborhood of the coupling point are referred to as co-ordinate systems a and b.

(2) The coupling angles are given as Euler angles, $\Psi$ ($\theta,\phi$, $\psi$)

Referring to Fig. 4, there are co-ordiante systems a (x, y, z) and b (X', Y', Z' ) , where

$\theta$--- angle between Z' and z,

$\phi$--- angle to X' of intersection OM between plane A containing Z' and z and plane B containing X' and Y',

and

$\psi$ --- angle to x of intersection ON between plane C containing x and y and plane A.

In co-ordinate conversion means 54a and 54b, a three-dimensional co-ordinate conversion matrix

$$
T = \begin{pmatrix}
\cos\theta\cos\varphi\cos\psi - \sin\varphi\sin\phi & -\cos\theta\cos\varphi\sin\psi - \sin\varphi\cos\psi & \sin\theta\cos\varphi \\
\cos\theta\sin\varphi\cos\psi + \cos\varphi\sin\phi & -\cos\theta\sin\varphi\sin\psi + \cos\varphi\cos\psi & \sin\theta\cos\psi \\
-\sin\theta\cos\phi & -\sin\theta\sin\phi & \cos\theta
\end{pmatrix} \cdots (67)
$$

is obtained from Euler's angles $\theta$, $\phi$ and $\psi$ concerning three-dimensional co-ordinate conversion defined by the sub structure coupling definition data memory 53. However, Euler's angles $\theta$, $\phi$ and $\psi$ concerning three-dimensional co-ordinate conversion defined by the sub structure coupling definition data memory are determined by the following method. The co-ordinate system before the conversion by a (x, y, z ) and that after the conversion is denoted by b (x', y', z' ).

For example, the Euler's angles when angle is rotated as x and y axes about z axis without conversion thereof are $\theta$ = 0 $\phi$ = 2 and $\psi$ = 0 or $\theta$ = 0, $\phi$ = 0 and $\psi$ = $\alpha$.

More specifically, when z asix itself is unchanged, $\theta$ = 0 and $\psi$ + $\phi$ = $\alpha$. Thus,

$$T_z = \begin{pmatrix} \cos \alpha & -\sin \alpha & 0 \\ \sin \alpha & \cos \alpha & 0 \\ 0 & 0 & 1 \end{pmatrix} \qquad \cdots (68)$$

When z axis itself is unchange,

$$T_y = \begin{pmatrix} \cos \theta & 0 & \sin \theta \\ 0 & 1 & 0 \\ -\sin \theta & 0 & \cos \theta \end{pmatrix} \qquad \cdots (69)$$

More specifically, assuming a co-ordinate system of a sub structure at a certain coupling point to be b co-ordinate system and a co-ordinate system of the coupled structure to be a co-ordinate system, $x' = x^b$ $\cdots$ $r' = r^b$ and $x = x^a \cdots r = r^a$ in Fig. 4, and considering conversion of freedom degrees $x^b$, $y^b$, $z^b$, $p^b$, $q^b$ and $r^b$ of the b co-ordinate system to freedom degrees $x^a$, $y^a$, $z^a$, $p^a$, $q^a$, and $r^a$ of the a co-ordinate system,

$$\begin{Bmatrix} x^a \\ y^a \\ z^a \\ p^a \\ q^a \\ r^a \end{Bmatrix} = \begin{pmatrix} T & 0 \\ & \\ 0 & T \end{pmatrix} \begin{Bmatrix} x^b \\ y^b \\ z^b \\ p^b \\ q^b \\ r^b \end{Bmatrix} \qquad \cdots (70)$$

Substituting $[\Gamma] = \begin{pmatrix} T & 0 \\ 0 & T \end{pmatrix}$

$$\begin{Bmatrix} x^a \\ y^a \\ z^a \\ p^a \\ q^a \\ r^a \end{Bmatrix} = [\Gamma] \begin{Bmatrix} x^b \\ y^b \\ z^b \\ p^b \\ q^b \\ r^b \end{Bmatrix} \qquad \cdots (71)$$

$T^{-1}$ is calculated with respect to T obtained in equation (67).

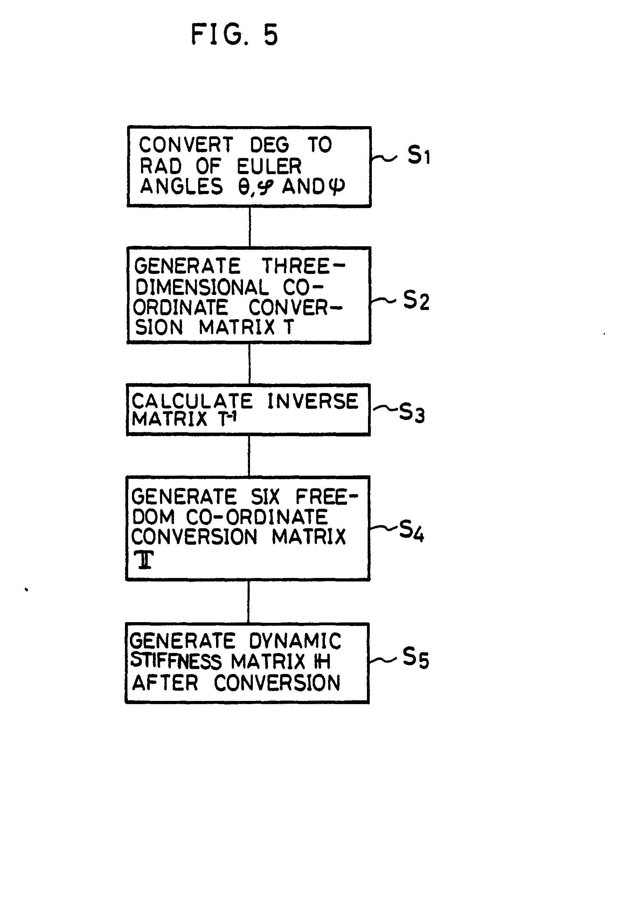

Fig. 5 is a flow chart of conversion of the degree (DEG) into radian (RAD) by co-ordinate conversion means 54a and 54b. In step S2 T in equation (67) is obtained, and its inverse matrix $T^{-1}$ is calculated in step S3. In step S4 co-ordinate conversion matrix |P is produced. In step S5 dynamic stiffness matrix |H after conversion is produced from $|H = [|\Gamma^{-1}]\,[|H]\,[|\Gamma]$, where [H] is the dynamic stiffness matrix before conversion.

Further, inverse matrix $[\Gamma^{-1}]$ to angular conversion matrix $[\Gamma]$ of the entire sub structures is produced for

14

directions x to z and p to r of freedom degrees defined with the sub structures for elements of the 3 by 3 matrix of $T^{-1}$, If the freedom degrees defined by the local structure are x to z and p to r in the metnioned order,

$$
[\Gamma^{-1}] = \begin{pmatrix} T^{-1} & 0 \\ \\ 0 & T^{-1} \end{pmatrix} \qquad \cdots (72)
$$

The equation of motion

$$
\begin{pmatrix} 0 & 0 & 0 & -I \\ 0 & H_{ii} & 0 & \Gamma^T \\ 0 & 0 & H_{rr} & 0 \\ -I & \Gamma & 0 & 0 \end{pmatrix} \begin{Bmatrix} X_d \\ X_i \\ X_r \\ P_d \end{Bmatrix} = \begin{Bmatrix} F_d \\ 0 \\ F_r \\ 0 \end{Bmatrix} \qquad \cdots (26)
$$

shown in the prior art example is disassembled to obtain equations.

$-\{P_d\} = \{F_d\}$  (73)

$[H_{ii}]\{X_i\} + [\Gamma]\{P_d\} = 0$  (74)

$[H_{rr}]\{X_r\} = \{F_r\}$  (75)

$-\{X_d\} + [\Gamma]\{X_i\} = 0$  (76)

From equation (73) and (74)

$[H_{ii}]\{X_i\} = [\Gamma^T]\{F_d\}$  (77)

$\{X_i\} = [H_{ii}]^{-1}[\Gamma^T]\{F_d\}$  (78)

Also, from equations (76) and (78)

$\{X_d\} = [\Gamma][H_{ii}]^{-1}[\Gamma^T]\{F_d\}$  (79)

$\therefore [\Gamma]^{-1}[H_{ii}]^{-1}[\Gamma^T]^{-1}\{X_d\} = \{F_d\}$  (80)

$\therefore [\Gamma^{-1}]^T[H_{ii}]^{-1}[\Gamma^{-1}]\{X_d\} = \{F_d\}$  (81)

From equations (75) and (81) we obtain a matrix.

$$
\begin{pmatrix} [\Gamma^{-1}]^T[H_{ii}][\Gamma^{-1}] & 0 \\ 0 & [H_{rr}] \end{pmatrix} \begin{pmatrix} X_d \\ X_r \end{pmatrix} = \begin{pmatrix} F_d \\ F_r \end{pmatrix} \qquad \cdots (82)
$$

As shown above, equaiton (82) is derived from equation (23), and both the equations are equivalent. This equation (82) means that it may be solved after performing calculation of co-ordinate conversion of independent freedom degree $H_{ii}$ to $[\Gamma^{-1}]^T[H_{ii}][\Gamma^{-1}]$.

Thus, in co-ordinate conversion means 54a and 54b performs operation expressed as

$[H'(\omega)] = [\Gamma^{-1}]^T[H(\omega)][\Gamma^{-1}]$  (83)

(where T represents transposed) with respect to transfer function matrix $[H(\omega)]$ obtained from transfer function calculating means 52a and 52b, thus deriving transfer function matrix $[H'(\omega)]$ after co-ordinate conversion.

Coupling means 55 synthesizes transfer function [H1] to [Hn] of dynamic stiffness (force/displacement) of N elements obtained by transfer function calculating means 52a and 52b to produce an equation of motion based on transfer matrix [H] after coupling, given as

$$\left[ \begin{array}{c} \boxed{H_1} \\ \quad \boxed{H_2} \\ \quad \ddots \\ \quad\quad H_{n-1} \\ \quad\quad\quad \boxed{H_n} \end{array} \right] \left\{ X \right\} = \left\{ F \right\}$$

$$\underset{\text{[H]}}{\parallel} \qquad\qquad \cdots (84)$$

When coupling is performed, like freedom degree data as noted in connection with the prior art example are added together. Where there is constraint relation among freedom degrees given as

$\{X_d\} = [\Gamma] \{X_i\}$   (85)

where $X_i$ represents independent degree of freedom, $X_d$ dependent degree of freedom, and $[\Gamma]$ constraint relation matrix, the equation of motion after coupling is

$$\begin{pmatrix} H_{dd} & H_{di} & H_{dr} & -I \\ H_{id} & H_{ii} & H_{ir} & \Gamma \\ H_{rd} & H_{ri} & H_{rr} & 0 \\ -I & \Gamma & 0 & 0 \end{pmatrix} \begin{Bmatrix} X_d \\ X_i \\ X_r \\ P \end{Bmatrix} \begin{Bmatrix} F_d \\ F_i \\ F_r \\ 0 \end{Bmatrix} \qquad \cdots (86)$$

However,

$$\left[ \begin{array}{l} [H] = \begin{pmatrix} H_{dd} & H_{di} & H_{dr} \\ H_{id} & H_{ii} & H_{ir} \\ H_{rd} & H_{ri} & H_{rr} \end{pmatrix}, \; [X_r] : \text{Constraint} \\ \qquad\qquad\qquad\qquad\qquad \text{relation free from} \\ \qquad\qquad\qquad\qquad\qquad \text{degree of freedom} \\ \{P\} : \text{Constraint force} \\ \begin{pmatrix} F_d \\ F_i \\ F_r \end{pmatrix} : \text{Force vector} \end{array} \right]$$

Frequency zone response analysis means 57 solves equation (84) or (86) of motion obtained by coupling means 55 to obtain response value of real degree of freedom. Further, when there is no damping, eigen value analysis means 59 separates the transfer function of dynamic stiffness (force/displacement) obtained from coupling means 55 to mass matrix [M] and stiffness matrix [K] using an equation

$[H] = -\omega 2 [M] + [K]$   (87)

and solves eigen value problem

$[M] \{ \ddot{X} \} + [K] \{X\} = \{0\}$   (88)

This is referred to as sub-space method.

16

When there is damping, the designated frequency range is divided, motion (84) or (86) of equation is solved for each frequency, and the response peak value is searched to obtain eigen value and eigen mode. This is referred to as frequency search process.

Fourier analysis means 62 performs FFT (fast Fourier transform of vibration application condition given in time zone to obtain frequency zone vibration application data, and inverse Fourier analysis means 63 performs inverse FFT of response analysis results obtained in frequency zone response analysis means 58 to obtain time zone response analysis relsults. Fourier analysis means 62 and inverse Fourier analysis means 63 are used when and only when time zone response results are necessary.

Now, the overall operation of this embodiment will be described. The structure coupling simulation system of this embodiment is constituted by program control. The program is usually stored in an auxiliary memory (not shown) as non-volatile memory, and at the time of initialization it is loaded in main memory 66 and executed by CPU 65.

In this system, sub structure data is stored in advance as input data in sub structure data memories 51a and 51b, co-ordinate conversion data and coupling definition data are stored in advance in sub structure coupling data memory 53, and vibration application data are stored in time zone data memory 61 when performing time zone analysis while they are stored in frequency zone data memory 56 when performing frequency zone analysis. CPU 65 reads out data from memories 51a, 51b, 53, 61 and 56 according to the program, performs simulation analysis using main memory 66 and stores the results in frequency response result memory 58, time zone response result memory 64 and eigen value analysis result memory 60. These memories are all on a magnetic disk system. Particularly, memories 58, 64 and 60 which provide results may be implemented by a line printer system. Further, memories 58, 64 and 60 may be used to produce flange with flag generation program using their output data as input data. Transfer function calculating means 52 calculates transfer function using equations (52) to (66) for conversion depending on the kind of sub structure data. When the transfer function is of compliance (displacement/force) type, it is converted to one of dynamic stiffness matrix (force/displacement) type using eqaution (51) to obtain transfer matrix of dynamic stiffness. Co-ordinate conversion means 54 converts transfer matrix of dynamic stiffness obtained by transfer function calculating means into transfer function matrix of overall structure co-ordinate system using the equations of conversion. Coupling means 55 synthesizes transfer function after coupling using equation (84). When there is constraint relation of degrees of freedom as given by equation (85), the constraint relation eqaution is also incorporated to produce overall system matrix and produce matrix of equation (86). Frequency response analysis means 57 solves equation (86) of motion. In case of a system without damping, eigen value analysis means 59 solves eigen value using the sub-space process given by equations (87) and (88). When there is damping, response for each frequency in the designated frequency range is solved to search peak value of response and determine eigen value, the eigen value thus obtained being substituted into eigen value analysis memory 60.

Fourier analysis means 62 converts vibration application data given in time zone into those in frequency zone, the converted data being stored in frequency zone vibration application data memory 56. Inverse Fourier analysis means 63 converts response results obtained in the frequency zone to those in the time zone, the converted data being stored in time zone response result memory 64.

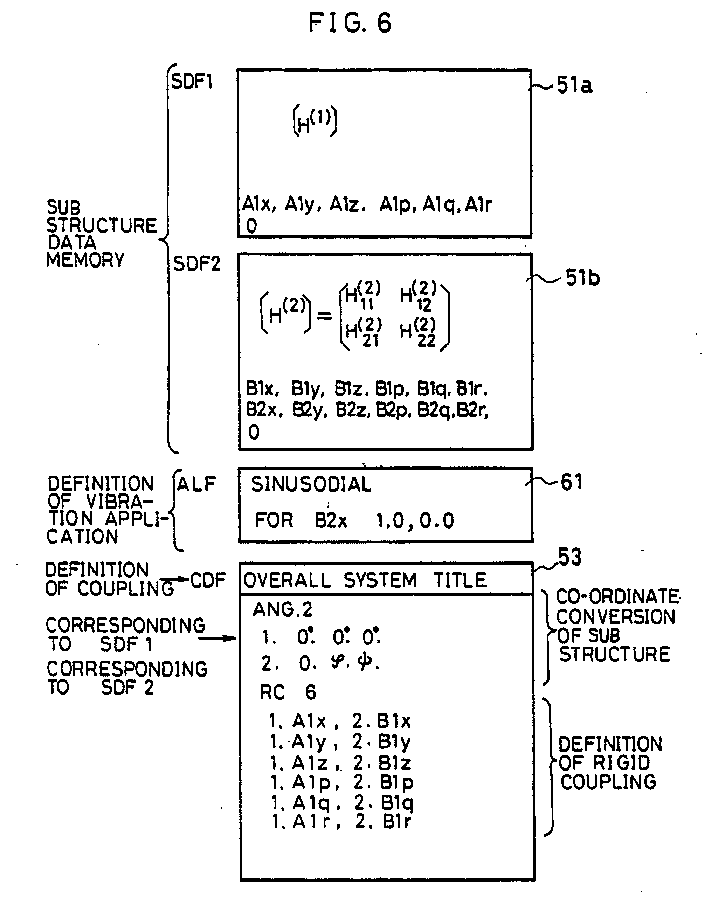

Now, a specific example of the invention will be described with reference to the drawings. Fig. 6 shows a case of application of the invention to the prior art example of Fig. 12(a). Designated at 51a and 51b are sub structure data memories SDF1 and SDF2, at 61 time zone vibration application data memory ALF, and at 53 sub structure coupling definition data memory CDF. In memory SDF1 transfer function matrix $[H^{(1)}]$ of sub structure 1 and six freedom degrees are defined. In memory SDF2 transfer function matrix $[H^2]$ measured by B1-B2 co-ordinate system of sub structure 2 and 12 freedom degrees are defined. In memory ALF, it is defined to determine frequency response when an external force with an amplitude of 1.0 and a phase of 0.0 degree is applied to B2x. Memory CDF defines differences of angles of the co-ordinate systems of the sub structures with respect to the overall system co-ordinate systems. In ANG L2 and following, angles of two co-ordinate systems with respect to the overall sysem co-ordinate system are defined, and then Euler's angles in the individual sub structures are shown in each lines. This example shows that the co-ordinate system of sub structure 1 is $(1, 0^{\bullet}, 0^{\bullet}, 0^{\bullet})$, same as the co-ordinate system of the overall system and that the co-ordinate system of sub structure 2 has angles $\theta$, $\phi$ and $\psi$ of $(2, \theta, \phi, \psi)$ with respect to the co-ordinate system of the overall system.

Following RC 6 shows that there are six freedom degrees where the coupling condition is rigid coupling, indicating that freedom degree A1x of sub s truc ture 1 and freedom degree B1x of sub structure 2 are rigidly coupled together. Likewise, freedom degrees A1y and B1y, $\bullet\bullet\bullet$, A1r and B1r are rigidly coupled together. This means that freedom degrees A1 and B1 commonly have six degrees of freedom.

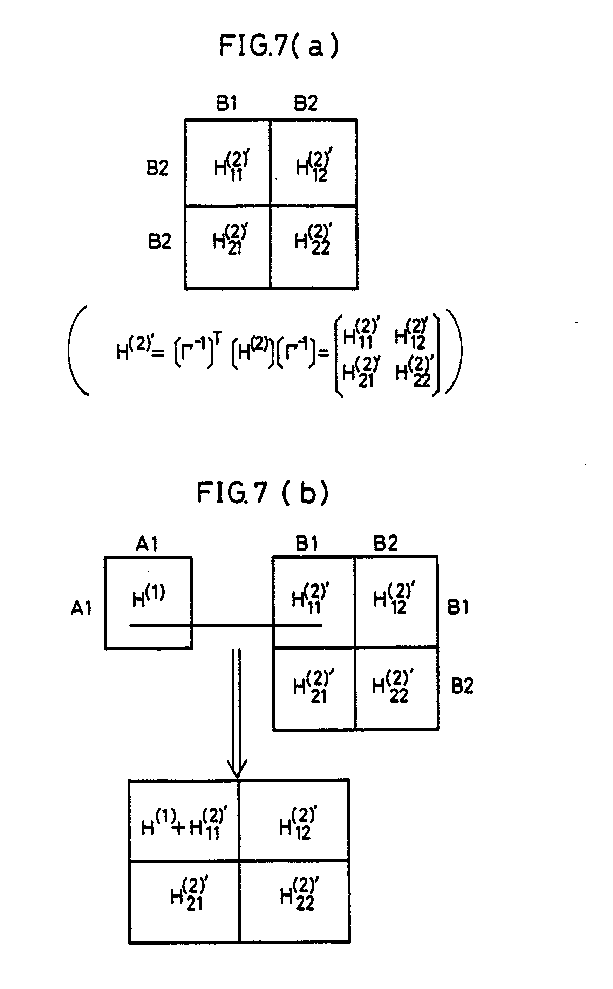

Fig. 7 is a view showing a transfer function matrix of the overall system in the above setting. Shown in (a) is the result of co-ordinate conversion obtained by performing calculation of equation (83) with respect to transfer function $H^{(1)}$ of sub structure 2. Shown in (b) is a method of bombining the transfer functions of sub structure 1 and sub structure 2 after co-ordinate conversion to synthesize the transfer function matrix of the overall system. $H^{(1)}$ and $H_{11}^{(2)'}$ permit calculation of equation (13) for the same co-ordinate system. In this way, the matrix calculation is performed within 12 by 12 size, which is one-fourth the size both in rows and columns compared to the prior art 36 by 36 size shown in Fig. 10.

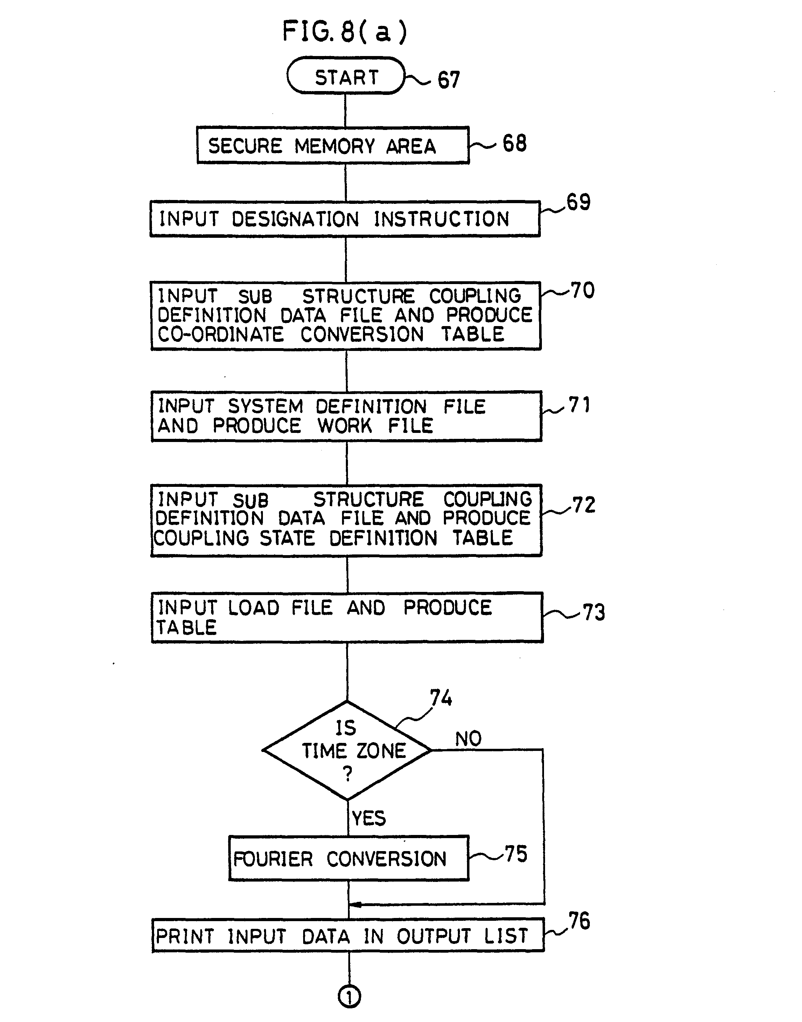

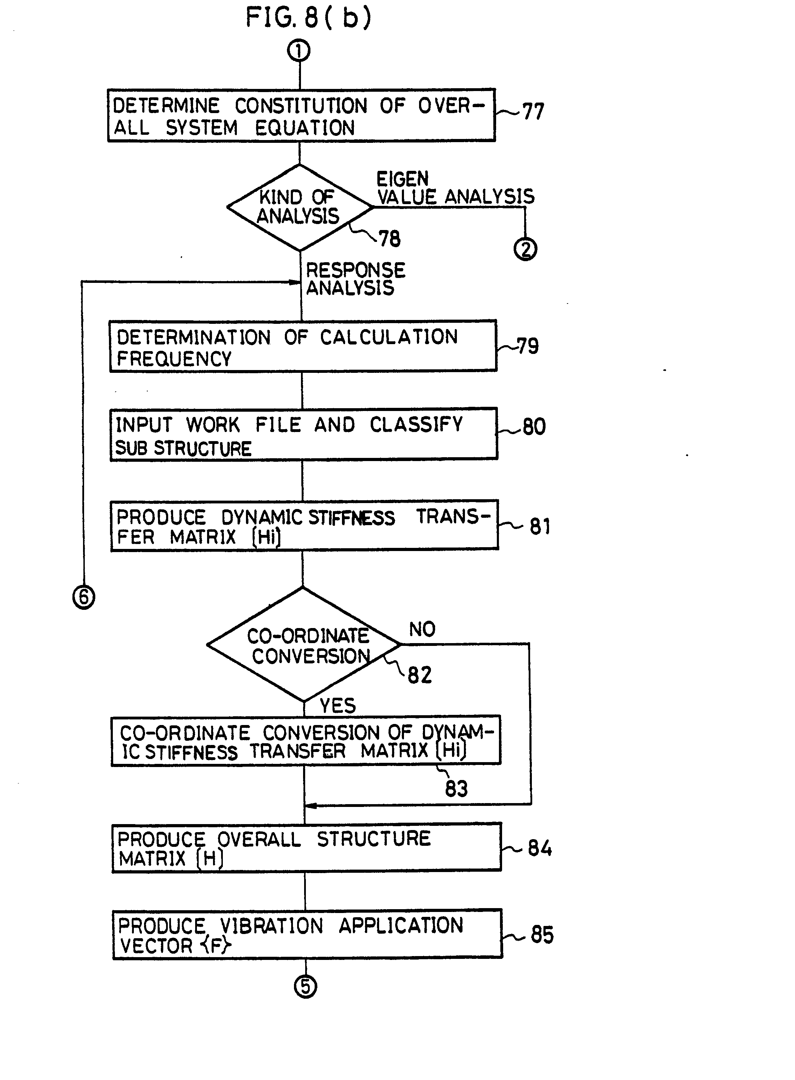

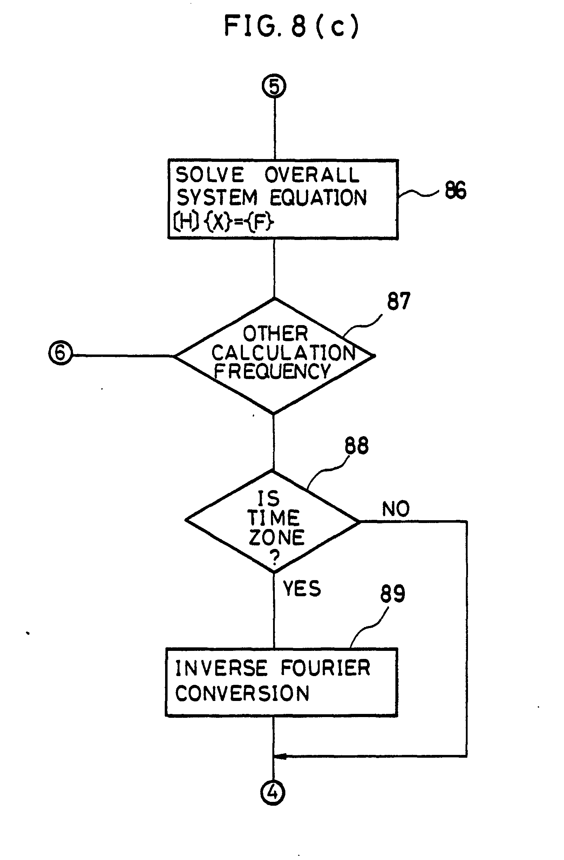

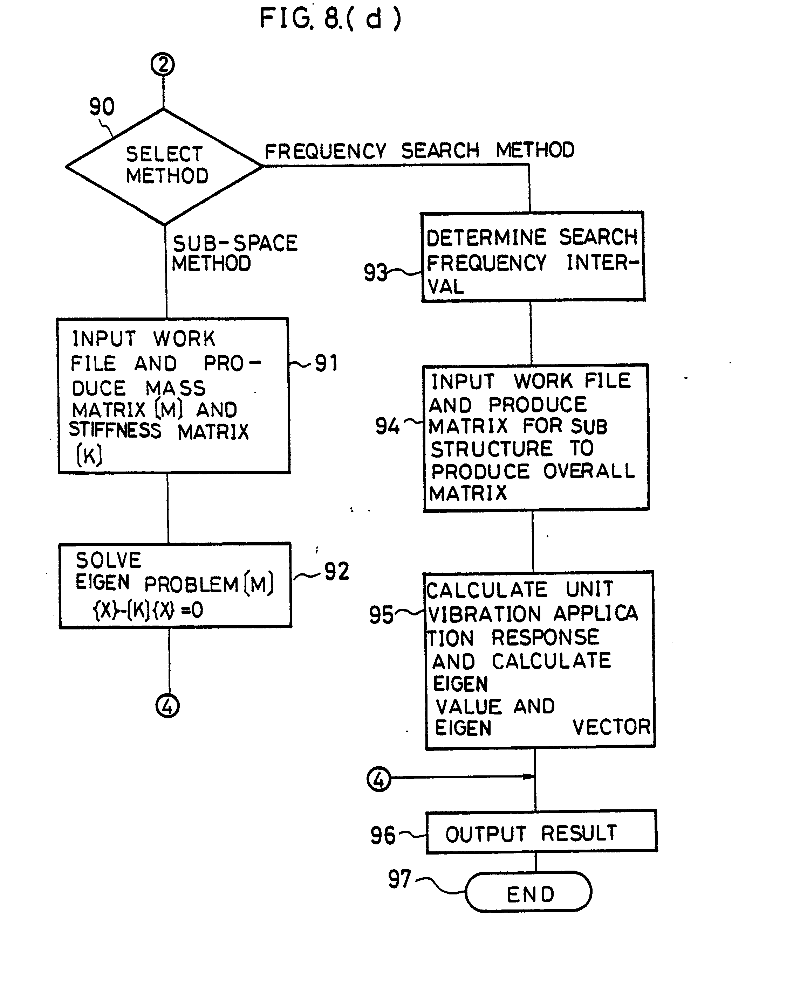

Now, Fig. 8 is a flow chart illustrating the operation of the system shown in Fig. 1. Designed at 67 to 97 are respective steps. In this program, in step 68 an area of main memory 66 used in the program is performed. In step 69, an input data memory, freedom degree for obtaining kind of reply in the method of analysis and and output data memory. In step 70, co-ordinate conversion data of sub structure coupling data memory is read out, Euler's angles $\theta$, $\phi$ and $\psi$ with respect to the coordinate conversion for each sub structure are stored in a co-ordinate conversion table in memory, and sub structures that constitute the overall structure are counted.

In step 71, sub structure data is stored in an operating file.

In step 72, coupling definition data in sub structure coupling data memory is read out, and if there is rigid coupling, relations where freedom degrees are equivalent are stored in a freedom degree table. If the coupling is soft coupling, scalar element data are added.

In step 73, local data is input to produce a table in main memory 66 at a designated position. In steps 74 and 75, Fourier analysis means 62 at the time of time zone data is shown. In step 76, contents of input sub struture data and load data are printed on an output list. In step 77, layout of main memory 66 used in the system is performed. In stpes 78 to 95, analysis is performed for various kinds of analysis with various methods. In step 96, results are output. Steps 79 through 89 show response calculation means. In the response analysis, processes in transfer function calculating means 52a and 52b, co-ordinate conversion means 54a and 54b, coupling means 55 and frequency zone response analysis means 57 are repeated in steps 79 to 87. In the response analysis in time zone, process of inverse Fourier analysis means 63 is performed in step 89. In steps 91 to 92, eigen value analysis based on the sub-space method is performed, and in steps 93 to 95 eigen value analysis based on frequency search method is performed. The response calculations used in steps 94 and 95 are the same as those in steps 80 to 86.

As has been described in the foregoing, in the structure vibration simulation system as an embodiment of the invention, unlike the prior art three-dimensional co-ordinate conversion system using constraint relation equation described above, a dynamic stiffness transfer matrix after co-ordinate conversion is obtained for each sub structure transfer matrix. Subsequently, a dynamic stiffness transfer function matrix is synthesized, the transfer function matrix after coupling is used to obtain eigen value and eigen mode of the overall structure, or the response analysis based on the frequency zone under vibration application conditions is obtained further FFT analysis on vibration application condition is effected in time zone, in frequency zone inverse FFT analysis is performed on the response to obtain response, and in this way dynamic characteristics of the structure after coupling are simulated.

As has been shown, in the above embodiment for data defining the vibration characteristics of the first and second local structures using equations (52) to (66) co-ordinate conversion means 54a and 54be are provided between transfer function calculating means 52a and 52b and coupling means 55.

Thus, there is no need of adding any constraint relation matrix to the overall system matrix, and it is possible to reduce necessary memory. That is, a least memory may be used for the overall system matrix. In addition, there is no possibility of occurrence of zero diagonal component, and it is possible to obtain accurate solution of symmetric matrix by the skyline method. (In the prior art, it was necessary to provide a differential as dyagonal component). Thus, it is possible to obtain vibration simulation of the structure accurately, quickly and with less memory capacity compared to the prior art.

Further, with this embodiment a desired number of sub structures can be coupled together at a time and at every angle. Thus, particularly when evaluating the reliability of a complicated machine design an overall evaluation can be obtained without performing complicated finite element method analysis with respect to the overall structure or experimental analysis after trial manufacture but from structure unit data. It is thus possible to obtain efficiency increase of the machine design.

While in the above embodiment eigen value analysis means 59 uses a sub-space method and frequency search method, the same effects can be obtained using other methods. Further, while memories 51a, 51b, 56, 61, 60, 58 and 64 use magnetic disk systems, memories 58, 66 and 64 storing output results may consists of line printers or the line.

Further, it is possible to provide the main memory with roles of vibration application data memory 56 for storing contents converted in Fourier conversion means 62 and frequency zone response result memory 58 for storing contents given as intermediate results of time zone analysis.

Further, it is possible to use any desired number of sub structure data memories 51a and 51b within the permissible memory capacity of the system.

Further, while sub structure coupling definition data memory 53 has two different kinds of data, i.e., coordiante conversion data and coupling definition data, it may be replaced with two separate memories having different functions.

Further, while the above embodiment has been described in conjunction with a structure vibration simulation apparatus used for the machine structure design in the fields of power plants, traffic, universe, communication, electronics, devices, electric home appliances and dwellings, the invention is also applicable not only to simulation of vibrations but also to characteristic analysis of coupled or organs consisting of other elements as apparatus for analyzing characteristics of an overall structure. For example, the invetion is applicable to numerical simulation for three-dimensional analysis of fluid and output simulation of electric circuit at the time of coupling.

Further, while in the above embodiment transfer functions are used for expressing characteristics, they are by no means limitative, and other methods of expression may be adopted.

As has been shown in the foregoing, according to the invention co-ordinate conversion means is provided between local characteristics calculating means and coupling means. It is thus possible to obtain analysis of characteristics of the overall system, thus further reducing time for producing data concerning characteristics analysis, time and labor for calculation and thus permitting great increase of the design efficiency.

**Claims**

1. An apparatus for analyzing coupling characteristics of a system consisting of a plurality of unit structures coupled to one another and having respective physical characteristics comprising:
a first memory for storing physical data of each said unit structure;
a plulality of calculating means each for calculating transfer function matrix of each said structure unit according to said physical data;
a second memory for storing definitions of co-ordinate conversion data and coupling concerning said structure units;
a plurality of co-ordinate conversion means for generating co-ordinate conversion matrices from said co-ordinate conversion data and converting said transfer function matrices into those in the overall system;
coupling means for coupling together said transfer function matrices in said overall system according to said definitions of coupling and generating transfer function matrices concerning said coupled system;
characteristics value analysis means for analyzing characteristic mode and mode shave of said coupled system according to said transfer function matrices;
a third memory for storing vibration application data in time zone with respect to each said structure unit;
Fourier analysis means for converting said vibration application data into those in frequency zone;
response analysis means for analyzing response in frequency zone concerning a point of measurement of said coupled system according to transfer function matrices from said coupling means and vibration application data in frequency zone; and
inverse Fourier analysis means for converting the results of said response analysis into those in time zone.

2. The apparatus according to claim 1, wherein said first to third memories are provided on a magnetic disk unit.

3. A method of analyzing coupling characteristics comprising:
a step of calculating transfer function matrix of each of a plurality of structure units from physical data thereof;
a step of generating co-ordinate conversion matrices from co-ordinate conversion data of each said unit structure, and converting said transfer function matrices into those in the overall system;
a step of coupling together said transfer function matrices in said overall system according to definitions of coupling and generating transfer function matrices concerning a coupled system obtained by coupling together said unit structures;
a step of analyzing eigen mode and mode shape of said coupled system according to said transfer function matrices;
a step of converting vibration application data in time zone with respect to said unit structures through Fourier analysis into those in frequency zone;
a step of analyzing response to vibrations in frequency zone converning a point of measurement on said coupled system from transfer function matrices of said coupled system and vibration application data in frequency zone; and

a step of performing inverse Fourier conversion of the results of said response analysis into those in time zone.

4. The method according to claim 3, wherein said physical data is obtained by measuring or analyzing vibrations of said unit structures.

5. The method according to claim 3, wherein said co-ordinate conversion data are three-dimensional co-ordinates of Euler angle.

6. The method according to claim 3, wherein said definitions of coupling are specified as rigid or soft coupling of said unit structures to one another.

7. The method according to claim 3, wherein said point of measurement consists of a plularity of degrees of freedom.

8. The method according to claim 3, wherein said transfer function matrices are calculated form data obtained through experimental FFT analysis of infinite element process analysis.

9. The method according to claim 3, wherein said transfer function matrices consist of those of compliance (displacement/force) and dynamic stiffness (force/displaceme nt).

## FI G. 1

53 — SUB STRUCTURE COUPLING DEFINITION DATA MEMORY

51a — SUB STRUCTURE DATA MEMORY 1

51b — SUB STRUCTURE DATA MEMORY 2

61 — TIME ZONE VIBRATION APPLICATION DATA MEMORY

52a — TRANSFER FUNCTION CALCULATION MEANS

52b — TRANSFER FUNCTION CALCULATION MEANS

62 — FOURIER ANALYSIS MEANS

54a — CO-ORDINATE CONVERSION MEANS

54b — CO-ORDINATE CONVERSION MEANS

56 — FREQUENCY ZONE VIBRATION APPLICATION DATA MEMORY   IN

55 — COUPLING MEANS

59 — EIGEN VALUE ANALYSIS MEANS

57 — FREQUENCY ZONE RESPONSE ANALYSIS MEANS

60 — EIGEN VALUE ANALYSIS COUPLING MEMORY

58 — FREQUENCY ZONE RESPONSE RESULT MEMORY

63 — INVERSE FOURIER ANALYSIS MEANS

64 — TIME ZONE RESPONSE RESULT MEMORY

# FIG. 2

# FIG. 3

SUB STRUCTURE 1
SUB STRUCTURE 2
$\psi(\theta, \varphi, \psi)$

# FIG. 4

PLANE A

PLANE B

PLANE C

# FIG. 5

CONVERT DEG TO RAD OF EULER ANGLES $\theta, \varphi$ AND $\psi$   ~ S1

GENERATE THREE-DIMENSIONAL CO-ORDINATE CONVER-SION MATRIX T   ~ S2

CALCULATE INVERSE MATRIX $T^{-1}$   ~ S3

GENERATE SIX FREE-DOM CO-ORDINATE CONVERSION MATRIX $\mathbb{T}$   ~ S4

GENERATE DYNAMIC STIFFNESS MATRIX $\mathbb{H}$ AFTER CONVERSION   ~ S5

# FIG. 6

SDF1

SUB STRUCTURE DATA MEMORY

$[H^{(1)}]$

A1x, A1y, A1z. A1p, A1q, A1r
0

~51a

SDF2

$$[H^{(2)}] = \begin{pmatrix} H^{(2)}_{11} & H^{(2)}_{12} \\ H^{(2)}_{21} & H^{(2)}_{22} \end{pmatrix}$$

B1x, B1y, B1z. B1p, B1q. B1r.
B2x, B2y, B2z, B2p, B2q, B2r,
0

~51b

DEFINITION OF VIBRATION APPLICATION

ALF

SINUSODIAL

FOR B2x 1.0, 0.0

~61

DEFINITION OF COUPLING → CDF

OVERALL SYSTEM TITLE

ANG.2
1. 0°. 0°. 0°.
2. 0. φ. φ.

RC 6

CORRESPONDING TO SDF 1

CORRESPONDING TO SDF 2

1. A1x , 2. B1x
1. A1y , 2. B1y
1. A1z , 2. B1z
1. A1p , 2. B1p
1. A1q , 2. B1q
1. A1r , 2. B1r

~53

CO-ORDINATE CONVERSION OF SUB STRUCTURE

DEFINITION OF RIGID COUPLING

# FIG.7( a )

$$H^{(2)'} = \left[\Gamma^{-1}\right]^T \left[H^{(2)}\right]\left[\Gamma^{-1}\right] = \begin{pmatrix} H_{11}^{(2)'} & H_{12}^{(2)'} \\ H_{21}^{(2)'} & H_{22}^{(2)'} \end{pmatrix}$$

# FIG.7 ( b )

# FIG. 8 ( a )

```
        ( START )────67
           │
  ┌──────────────────────┐
  │ SECURE MEMORY AREA    │────68
  └──────────────────────┘
           │
┌────────────────────────────┐
│ INPUT  DESIGNATION  INSTRUCTION │────69
└────────────────────────────┘
           │
┌────────────────────────────┐
│ INPUT  SUB   STRUCTURE COUPLING │────70
│ DEFINITION DATA FILE AND PRODUCE │
│ CO-ORDINATE CONVERSION TABLE    │
└────────────────────────────┘
           │
┌────────────────────────────┐
│ INPUT SYSTEM DEFINITION  FILE │────71
│ AND  PRODUCE  WORK  FILE      │
└────────────────────────────┘
           │
┌────────────────────────────┐
│ INPUT SUB     STRUCTURE  COUPLING │────72
│ DEFINITION DATA FILE AND PRODUCE │
│ COUPLING STATE DEFINITION TABLE │
└────────────────────────────┘
           │
┌────────────────────────────┐
│ INPUT LOAD FILE AND PRODUCE   │────73
│ TABLE                         │
└────────────────────────────┘
           │
          ╱◇╲ 74
        ╱  IS  ╲
       ◇ TIME ZONE ◇──NO──┐
        ╲   ?   ╱          │
          ╲◇╱             │
           │ YES           │
  ┌──────────────────┐     │
  │ FOURIER CONVERSION│──75 │
  └──────────────────┘     │
           │◄──────────────┘
┌────────────────────────────┐
│ PRINT INPUT DATA IN OUTPUT LIST │────76
└────────────────────────────┘
           │
          (①)
```

27

# FIG. 8 ( b )

①

| DETERMINE CONSTITUTION OF OVER-ALL SYSTEM EQUATION | ~77 |

KIND OF ANALYSIS ~78

EIGEN VALUE ANALYSIS → ②

RESPONSE ANALYSIS

| DETERMINATION OF CALCULATION FREQUENCY | ~79 |

| INPUT WORK FILE AND CLASSIFY SUB STRUCTURE | ~80 |

| PRODUCE DYNAMIC STIFFNESS TRANS-FER MATRIX (Hi) | ~81 |

⑥

CO-ORDINATE CONVERSION ~82

NO

YES

| CO-ORDINATE CONVERSION OF DYNAMIC STIFFNESS TRANSFER MATRIX (Hi) |

83

| PRODUCE OVERALL STRUCTURE MATRIX (H) | ~84 |

| PRODUCE VIBRATION APPLICATION VECTOR {F} | ~85 |

⑤

# FIG. 8 (c)

⑤

SOLVE OVERALL
SYSTEM EQUATION
[H] {X}={F}          86

OTHER
CALCULATION     87
FREQUENCY

⑥

IS
TIME     88
ZONE
?              NO

YES     89

INVERSE FOURIER
CONVERSION

④

# FIG. 8.( d )

②

90 — SELECT METHOD ——————— FREQUENCY SEARCH METHOD

SUB-SPACE METHOD

```
93 ⌇ DETERMINE SEARCH
       FREQUENCY INTER-
       VAL
```

```
91 INPUT WORK
        FILE AND PRO-
        DUCE MASS
        MATRIX [M] AND
        STIFFNESS MATRIX
        [K]
```

```
94 ⌇ INPUT WORK FILE
        AND PRODUCE
        MATRIX FOR SUB
        STRUCTURE TO
        PRODUCE OVERALL
        MATRIX
```

```
92 SOLVE
        EIGEN PROBLEM [M]
        {X}-[K]{X} =0
```

```
95 ⌇ CALCULATE UNIT
        VIBRATION APPLICA
        TION RESPONSE
        AND CALCULATE
        EIGEN
        VALUE AND
        EIGEN        VECTOR
```

④

④ ——————→

96 ⌇ OUTPUT RESULT

97 ⌇ END

FIG.9

VIBRATION CHARACTERISTIC OF ELEMENT

VIBRATION CHARACTERISTIC OF OVERALL SYSTEM

THEORETICALLY (SUCH AS FINITE ELEMENT METHOD)

EXPERIMENTALLY

SUB STRUCTURE SYNTHESIS METHOD

100: CAR BODY
101: CHASSIS
102: BASE A
103: BASE B
110~113. 121: VIBRATION CHARACTERISTIC

EP 0 406 020 A2

FIG.10 PRIOR ART

$H^{(1)}$

$H_{mr}^{(3)}$ (POINT OF COUPLING
OF SUB STRUC-
TURES 1 AND 3)

$H_{mr}^{(N)}$ (POINT OF COUPLING OF
SUB STRUCTURES 2
AND N)

$H^{(2)}$

$H^{(3)}$

POINT OF COUPLING OF
SUB STRUCTURES
2 AND N

POINT OF COUPLING OF
SUB STRUCTURES
1 AND 2

POINT OF COUPLING OF
SUB STRUCTURES
1 AND 3

$H^{(N)}$

EP 0 406 020 A2

# FIG.11 PRIOR ART

```
    51a              51b                61
┌──────────────┐ ┌──────────────┐ ┌──────────────┐
│ SUB          │ │ SUB          │ │ TIME ZONE    │
│ STRUCTURE    │ │ STRUCTURE    │ │ VIBRATION    │
│ DATA MEMORY  │ │ DATA MEMORY  │ │ APPLICATION  │
│              │ │              │ │ DATA MEMORY  │
└──────────────┘ └──────────────┘ └──────────────┘
        │                │                │
        ▼                ▼                ▼
┌──────────────┐ ┌──────────────┐ ┌──────────────┐
│ TRANSFER     │ │ TRANSFER     │ │ FOURIER      │
│ FUNCTION     │ │ FUNCTION     │ │ ANALYSIS     │
│ CALCULATION  │ │ CALCULATION  │ │ MEANS        │
│ MEANS        │ │ MEANS        │ │              │
└──────────────┘ └──────────────┘ └──────────────┘
  52a              52b                62
```

EIGEN VALUE ANALYSIS MEANS — 59

SUB STRUCTURE COUPLING DEFINITION DATA MEMORY — 53

COUPLING MEANS — 55

FREQUENCY ZONE VIBRATION APPLICATION DATA MEMORY — 56

EIGEN VALUE ANALYSIS RESULT MEMORY — 60

57 — FREQUENCY ZONE RESPONSE ANALYSIS MEANS

58 — FREQUENCY ZONE RESPONSE RESULT MEMORY

63 — INVERSE FOURIER ANALYSIS MEANS

64 — TIME ZONE RESPONSE RESULT MEMORY

FIG.12
(a)
PRIOR
ART
(INPUT
DATA)

SUB
STRUCTURE 1

SUB
STRUCTURE 2

A2 (AFTER CO-ORDINARY
CONVERSION)

45°

(BEFORE CO-
ORDINARY
CONVERSION)

A1 B1

B2

$x$

$y$

$z$

SDF

24
A1x, A1y, A1z, A1p, A1q, A1r.
A2x, A2y, A2z, A2p, A2q, A2r.
B1x, B1y, B1z, B1p, B1q, B1r
B2x, B2y, B2z, B2p, B2q, B2r

OVERALL
SYSTEM
FREEDOM
DEFINITION

51a

FIG.12
(b)
PRIOR
ART

$$\left[H^{(1)}\right] = \begin{bmatrix} Hxx - - - - - - - Hx,r \\ \vdots \qquad\qquad \vdots \\ Hrx - - - - - - - Hr,r \end{bmatrix} \updownarrow A1$$

$\longleftarrow$ A1 $\longrightarrow$

DEFINITION
OF SUB
STRUCTURE 1

SUB1. A1x, A1y $\sim$ , A1r.
0

51b

$$\left[H^{(2)}\right] = \begin{bmatrix} H^{(2)}_{11} & H^{(2)}_{12} \\ H^{(2)}_{21} & H^{(2)}_{22} \end{bmatrix} = \begin{bmatrix} Hxx - - - Hxr & Hxx - - - -Hx,r \\ \vdots \qquad \vdots & \vdots \qquad\quad \vdots \\ Hr.x - - - Hr.r & Hr.x - - - Hr.r \\ Hxx - - - Hx,r & Hxx - - - - Hxr \\ \vdots \qquad \vdots & \vdots \qquad\quad \vdots \\ Hr.x - - Hr.r & Hr.x - - -Hr.r \end{bmatrix}$$

$\longleftarrow$ B1 $\longrightarrow$  $\longleftarrow$ B2 $\longrightarrow$

B1

B2

DEFINITION
OF SUB
STRUCTURE 2

SUB2 B1x, B1y, $\sim$ , B1r.
B2x, B2y, $\sim$ , B2r.
0

# FIG.12 (c) PRIOR ART

ALF

61 — SINUSOIDAL
FOR A2X    1.0,0.0

VIBRATION
APPLICATION
DEFINITION

53 — CON 12,12

B1x, B1y, — — — — — — — — B1r
B2x, B2y, — — — — — — — — B2r
A1x, A1y, — — — — — — — — A1r
A2x, A2y, — — — — — — — — A2r

CONSTRAINT
RELATION
DEFINITION
(SETTING OF
CO-ORDINATE
CONVERSION
MATRIX)

$$[\Gamma] = \begin{bmatrix} \Gamma_{11} & \Gamma_{12} \\ \Gamma_{21} & \Gamma_{22} \end{bmatrix} = \begin{bmatrix} \Gamma x.x - - - \Gamma x.r & \Gamma x.x - - - \Gamma x.r \\ \Gamma r.x - - - \Gamma r.r & \Gamma r.x - - - \Gamma r.r \\ \Gamma x.x - - - \Gamma x.r & \Gamma x.x - - - \Gamma x.r \\ \Gamma r.x - - - \Gamma r.r & \Gamma r.x - - - \Gamma r.r \end{bmatrix}$$

←— B1 —→  ←— B2 —→

A1 / A2

EP 0 406 020 A2

# FIG.13

# FIG. 14 PRIOR ART

|       |       | BASE SECTION | | | | EXPANSION SECTION | |
|-------|-------|------|------|------|------|------|------|
|       |       | A1 | B1 | B2 | A2 | A1 | A2 |
| BASE SECTION | A1 | $H^{(1)}$ | 0 | 0 | 0 | −1 | 0 |
|       | B1 | 0 | $H_{11}^{(2)}$ | $H_{12}^{(2)}$ | 0 | $\Gamma_{11}^{T}$ | $\Gamma_{12}^{T}$ |
|       | B2 | 0 | $H_{21}^{(2)}$ | $H_{22}^{(2)}$ | 0 | $\Gamma_{21}^{T}$ | $\Gamma_{22}^{T}$ |
|       | A2 | 0 | 0 | 0 | 0 | 0 | −1 |
| EXPANSION SECTION | A1 | −1 | $\Gamma_{11}$ | $\Gamma_{12}$ | 0 | 0 | 0 |
|       | A2 | 0 | $\Gamma_{21}$ | $\Gamma_{22}$ | −1 | 0 | 0 |

DIAGONAL COMPONENTS OF BASE SECTION ARE 0.

( WHEN SOLVING SIMULTANEOUS LINEAR EQUATIONS AS SYMMETRIC MATRIX, NO ROW IS INTERCHANGED, THAT NO SOLUTION CAN BE OBTAINED UNLESS INFINITESIMAL VALUE IS SUBSTITUTED. )

⟶ CAUSE OF ERROR